Europäisches Patentamt

European Patent Office

Office européen des brevets

(11) Veröffentlichungsnummer: **0 146 938 B1**

# (12) EUROPÄISCHE PATENTSCHRIFT

(45) Veröffentlichungstag der Patentschrift: 20.02.91

(51) Int. Cl.⁵: **H04Q 1/32**, H04Q 3/54

(21) Anmeldenummer: 84115977.5

(22) Anmeldetag: 20.12.84

(54) Signalerkennungssystem.

(30) Priorität: 22.12.83 BE 898520

(43) Veröffentlichungstag der Anmeldung:
03.07.85 Patentblatt 85/27

(45) Bekanntmachung des Hinweises auf die
Patenterteilung:
20.02.91 Patentblatt 91/08

(84) Benannte Vertragsstaaten:
AT CH DE FR GB IT LI NL SE

(56) Entgegenhaltungen:
BE-A- 880 921
GB-A- 2 121 256

(73) Patentinhaber: ALCATEL N.V.
Strawinskylaan 537 (World Trade Center)
NL-1077 XX Amsterdam(NL)

(72) Erfinder: Sallaerts, Daniel
Kouterstraat 19
B-3220 Aarschot(BE)
Erfinder: Rahier, Michel Camille Auguste
René
Termikkelaan 16
B-2530 Boechout(BE)

(74) Vertreter: Vermeersch, Robert et al
BELL TELEPHONE MANUFACTURING COM-
PANY Naamloze Vennootschap Patent Department Francis Wellesplein 1
B-2018 Antwerp(BE)

EP 0 146 938 B1

## Beschreibung

Die Erfindung betrifft ein Signalerkennungssystem zum Erzeugen eines Ausgangssignalzustandes in Abhängigkeit von einem Eingangssignalzustand falls der Eingangssignalzustand wenigstens während eines vorgegebenen Zeitintervalles anliegt, wobei das Signalerkennungssystem eine Einheit zum periodischen Abtasten des Eingangssignalzustandes, eine erste Speichereinheit zum Abspeichern eines dem vorgegebenen Zeitintervall entsprechenden Anfangswertes, eine zweite Speichereinheit zum Abspeichern eines Wertes, der der Anzahl von Zeiteinheiten entspricht, die seit der Erkennung eines Unterschiedes zwischen einem Eingangs- und einem Ausgangssignalzustand gezählt wurden, eine dritte Speichereinheit zum Abspeichern des Ausgangssignalzustandes und eine Verarbeitungseinheit aufweist zum Übertragen des Anfangswertes von der ersten Speichereinheit zu der zweiten Speichereinheit falls kein Unterschied erkannt wurde, zum Abändern des in der zweiten Speichereinheit abgespeicherten Wertes jedesmal dann, wenn ein Unterschied erkannt wurde und zwar solange bis die Anzahl von Zeiteinheiten gezählt wurden, die dem vorgegebenen Zeitintervall entsprechen und zum anschließenden Wechseln des Ausgangssignalzustandes in der dritten Speichereinheit.

Es ist bereits ein Signalerkennungssystem bekannt (Belgisches Patent No. 880 921) indem die erste Speichereinheit für jeden Eingangssignalzustand einen Anfangswert zum Starten eines Zeitzählvorganges als auch die Reihe der folgenden Werte, die je um Eins vermindert wird, abspeichert. Diese Anfangs- und Folgewerte werden nacheinander in die zweite Speichereinheit übertragen, falls ein Unterschied zwischen einem Eingangs- und Ausgangssignalzustand erkannt wird und zwar solange bis der in der zweiten Speichereinheit abgespeicherte Wert anzeigt, daß ein vorgegebenes Zeitintervall gezählt wurde, d.h. bis das Ende des gestarteten Zeitzählervorganges erreicht wurde.

Daraus folgt, daß die erste Speichereinheit relativ groß ist und jedesmal, wenn in der zweiten Speichereinheit ein abgespeicherter Wert geändert werden muß, muß auf die erste Speichereinheit zugegriffen werden, um einen neuen Wert zu erhalten. Darüberhinaus muß für eine solche Operation der tatsächliche Eingangssignalzustand bekannt sein, da der nächstfolgende Wert eine Funktion dieses Zustandes ist.

Eine Aufgabe gemäß der Erfindung besteht darin, ein Signalerkennungssystem der eingangs genannten Art zu schaffen, das die Nachteile des Standes der Technik vermeidet.

Diese Aufgabe wird erfindungsgemäß dadurch gelöst, daß in der ersten Speichereinheit nur ein einziger Anfangswert für alle Zustände des Eingangssignals abgespeichert wird und daß die Verarbeitungseinheit die zweite Speichereinheit mit Hilfe des Anfangswertes initialisiert, welcher im folgenden immer dann durch eine 1-Bit-Addiereinheit geändert wird, wenn ein Unterschied erkannt wird und zwar unabhängig von der ersten Speichereinheit.

Daraus folgt, daß auf die relativ kleine erste Speichereinheit nicht jedesmal zugegriffen werden muß, wenn der in der zweiten Speichereinheit abgespeicherte Wert geändert wird. Darüberhinaus wird diese Änderung durch eine einfache Addiereinheit ausgeführt. Da die Geschwindigkeit einer solchen Addieroperation relativ niedrig ist, kann das gesamte System inklusive der Addiereinheit auf einer relativ kleinen Fläche integriert werden. Wenn z.B. MOS-Technologie benutzt wird, in der Datenaustausch durch Lade- und Entladevorgänge von parasitären Kapazitäten erfolgt, erlaubt eine relativ niedrige Geschwindigkeit die Verwendung von Transistoren, die relativ kleine Ströme für die Ladevorgänge benötigen und die daher auf einer relativ kleinen Fläche integriert werden können.

Aus der UK Patentanmeldung 2121256 ist bereits ein Signalerkennungssystem bekannt, in dem ein Mittel mit Hilfe eines Startwertes initialisiert wird, welches später nur in Abhängigkeit von dem Signalzustand geändert wird. Dieses Mittel ist als Filterzähler (Filter counter) realisiert, welcher z.B. mit einem Maximalwert initialisiert wird und welcher zu einer vorgegebenen Zeit nach der Detektion eines 1 zu 0 Wechsels des Leitungszustandes dekrementiert wird. Der neue Leitungszustand 0 wird nur erkannt, wenn der Zähler einen niedrigeren Schwellenwert erreicht, wobei der neue Zustand dann als neuer Zustand 1 registriert wird. In diesem bekannten System ist der Filterzähler ein Vielfach-Bit-Zähler, wobei in dem vorliegenden System eine zweite Speichereinheit und eine 1-Bit-Addiereinheit verwendet wird.

Ein weiteres charakteristisches Merkmal des vorliegenden Systemes besteht darin, daß die 1-Bit-Addiereinheit einen Summenausgang aufweist, der mit einem Eingang der zweiten Speichereinheit verbunden ist und weiterhin ein Exklusiv-ODER-Gatter enthält, welches die Eingangs- und Ausgangssignalzustände vergleicht und im Falle eines entdeckten Unterschiedes einen Ausgang der zweiten Speichereinheit mit der Addiereinheit verbindet, die dann einen 1-Wert zu dem in der zweiten Speichereinheit abgespeicherten Wert hinzuaddiert und den so erhaltenen Summenwert in der zweiten Speichereinheit abspeichert.

Durch den Gebrauch des Exklusiv-ODER-Gatters erfolgt die Abänderung des in der zweiten Speichereinheit abgespeicherten Wertes unabhängig von dem tatsächlichen Zustand des Eingangssignales.

2

Das zuvor Gesagte sowie andere Aufgaben ... und Merkmale der Erfindung werden nun im folgenden unter Bezugnahme auf die Zeichnungen anhand eines Ausführungsbeispiels erläutert.

Es zeigen:

Figur 1 und 2    ein Signalerkennungssystem gemäß der Erfindung

Figur 3    ein T-Kippglied gemäß der Erfindung nach Figur 1

Figur 4    eine bistabile Kippstufe gemäß der Erfindung nach Figur 1

Figur 5    eine Addiereinheit gemäß der Erfindung nach Figur 1

Figur 6    eine Speicherzelle der zweiten Speichereinheit gemäß der Erfindung nach Figur 2

Figur 7    eine Speicherzelle der ersten Speichereinheit gemäß der Erfindung nach Figur 2

Figur 8    die untere Reihe von Speicherzellen der ersten Speichereinheit und eine Steuereinheit gemäß der Erfindung

Figur 9    ein Impulsdiagramm der verschiedenen in Figur 1 und 2 auftretenden Signale

Figur 10 und 11    ein Zeitdiagramm zur Erläuterung der Abläufe des Signalerkennungssystems nach Figur 1 und Figur 9.

Das vorliegende Signalerkennungs- oder Signalentprellungssystem bildet einen Teil eines Fernsprechsystems und dient zur Entprellung von acht Fernsprechsignalen. Solche Signale sind z.B. Handapparat eingehängt/ausgehängt oder Rufabschaltung. Diese acht Fernsprechsignale $IN\emptyset$ bis $IN7$ sind an gleich benannte Signaleingänge $IN\emptyset$ bis $IN7$ geführt. Die entprellten Ausgangssignale werden an Signalausgängen $OUT\emptyset$ bis $OUT7$ bereitgestellt.

Das Signalentprellungssystem enthält die folgenden, wie den Zeichnungen zu entnehmen ist, untereinander verbundenen Schaltungen:

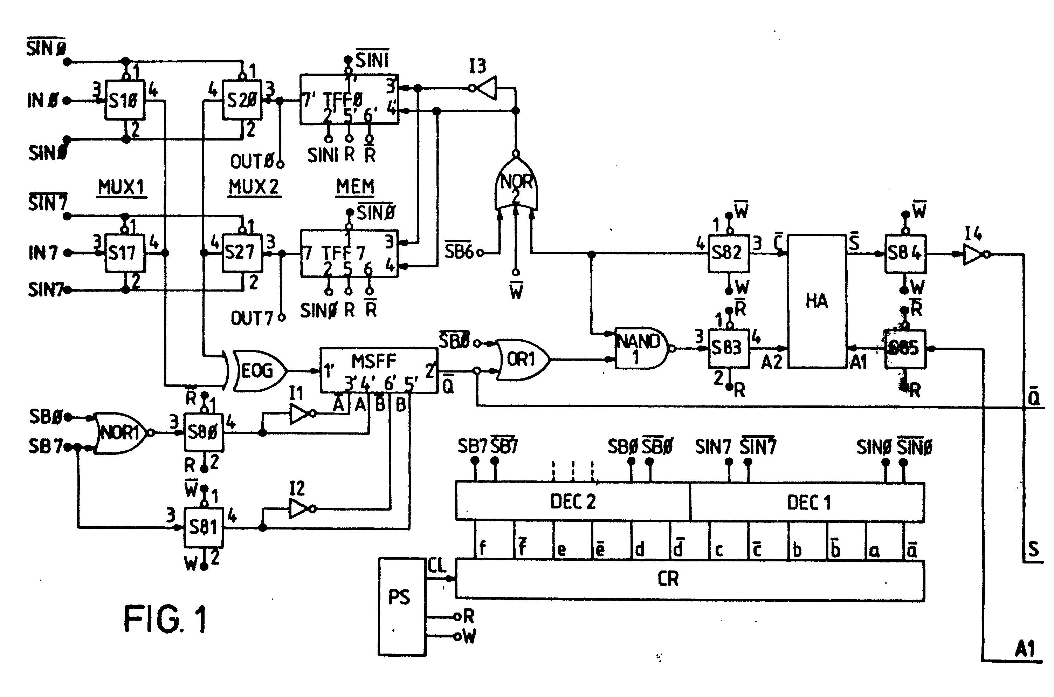

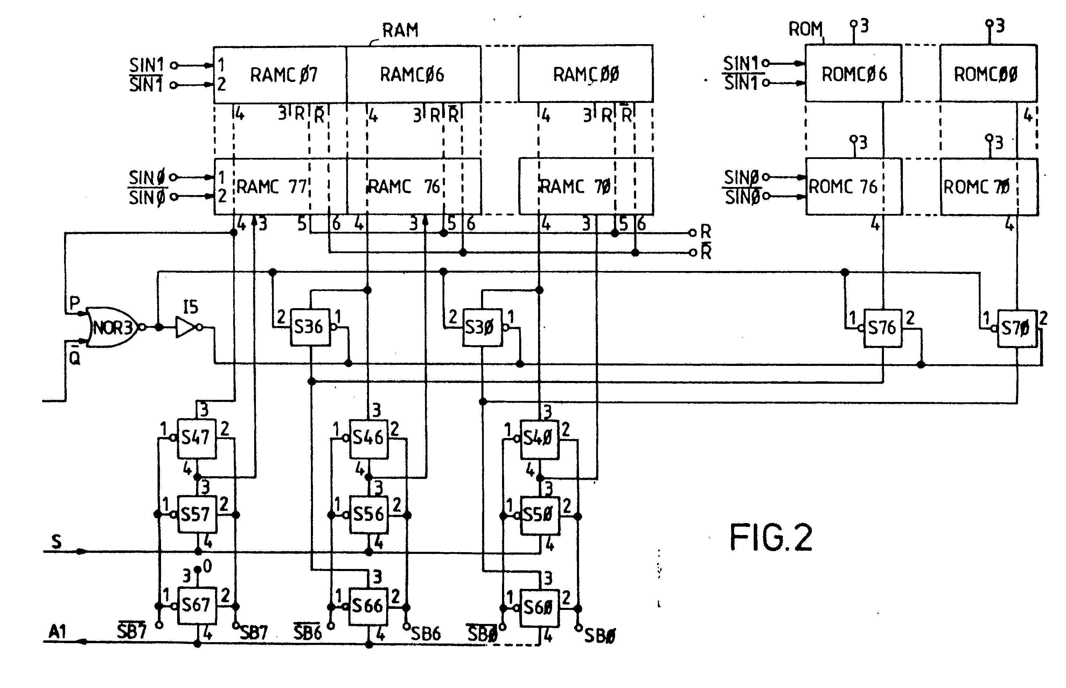

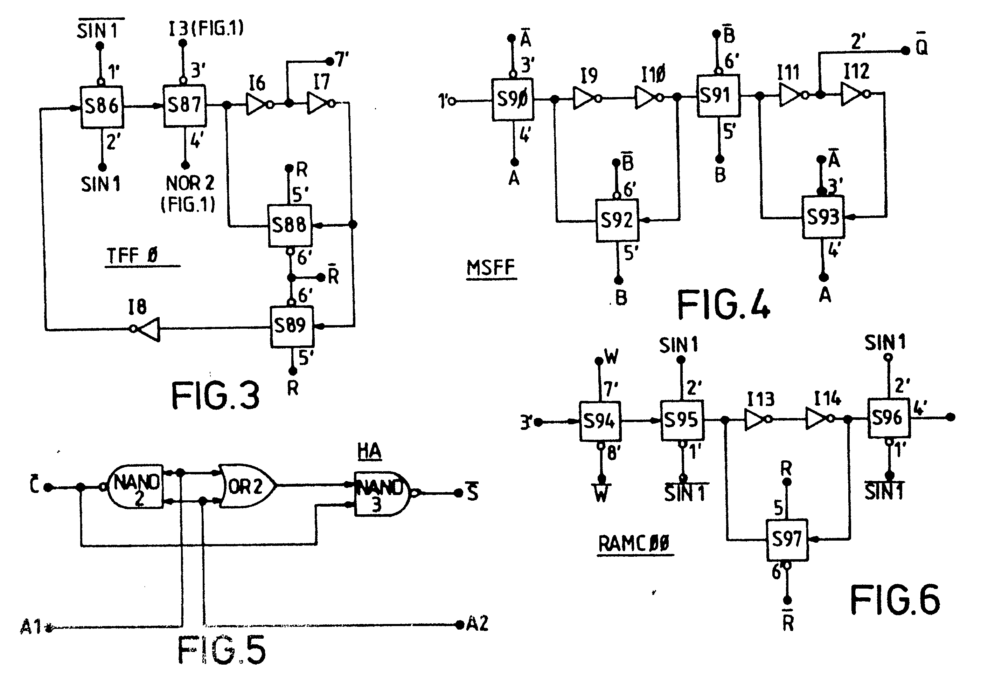

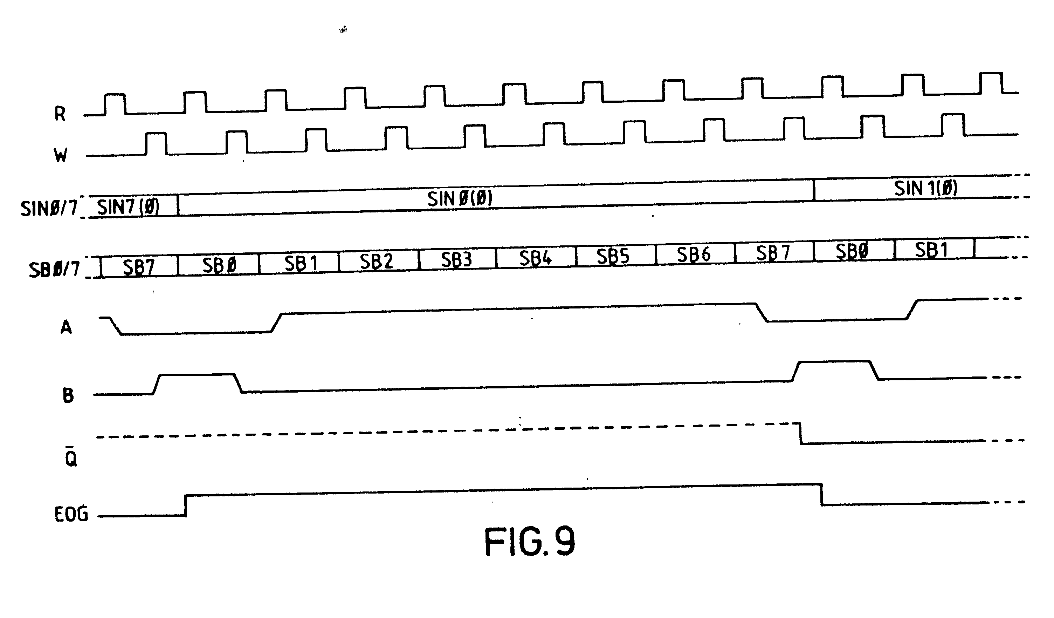

- eine Zeitgeberschaltung mit einem Taktgenerator PS (vgl. Figur 1), der ein Taktsignal CL und Schreib-, Lesesignale W, R (vgl. Figur 9) mit einer Taktperiode von $\frac{2}{64}$ ms erzeugt, wobei das Lesesignal R und das Schreibsignal W in der Phase um $180°$ zueinander gedreht sind;

- mit einem Binärzähler CR (vgl. Figur 1), der komplementäre Binärausgänge a, $\bar{a}$ bis f, $\bar{f}$ aufweist, wobei an den Binärausgängen a, $\bar{a}$ das höchstwertige Bit und an den Binärausgängen f, $\bar{f}$ das niedrigstwertige Bit anliegt. Der Binärzähler CR wird durch das Taktsignal CL getaktet und erzeugt an seinen Binärausgängen a, b, c ( $\bar{a}$ , $\bar{b}$ , $\bar{c}$ ) und an seinen Binärausgängen d, e, f ( $\bar{d}$ , $\bar{e}$ , $\bar{f}$ ) alle $\frac{2}{8}$ ms bzw. $\frac{2}{64}$ ms ein unterschiedliches 3-Bit Ausgangssignal;

- mit einer ersten Binär-Dezimalwandlereinheit DEC1 (vgl. Figur 1), die jedes von den Binärausgängen a, b, c ( $\bar{a}$ , $\bar{b}$ , $\bar{c}$ ) ankommende 3-Bit Eingangssignal in ein 1 aus 8 Eingangswahlsignal oder Zeitintervallsignal $SIN\emptyset/7$ ( $\overline{SIN\emptyset/7}$ ) wandelt, vgl. Fig. 9, wobei jedes ein Eingangszeitintervall von $\frac{2}{8}$ ms erzeugt;

- und mit einer zweiten Binär-Dezimalwandlereinheit DEC2 (vgl. Fig. 1), die jedes von den Binärausgängen d, e, f ( $\bar{d}$ , $\bar{e}$ , $\bar{f}$ ) ankommende 3-Bit Eingangssignal in ein 1 aus 8 Auswahlbitsignal oder Bittaktsignal $SB\emptyset/7$ ( $\overline{SB\emptyset/7}$ ) wandelt, vgl. Fig. 9, wobei jedes einen Bittakt von $\frac{2}{64}$ ms erzeugt;

- einen ersten Multiplexer MUX1 mit Schalter $S1\emptyset$ bis Schalter S17 (vgl. Fig. 1)

- einen zweiten Multiplexer MUX2 mit Schalter $S2\emptyset$ bis Schalter S27 (vgl. Fig. 1)

- eine dritte Speichereinheit MEM (vgl. Fig. 1), die T-Kippglieder $TFF\emptyset$ bis TFF7 aufweist, wobei jedes T-Kippglied einen ersten und vierten Schalter S86, S87, S89, S88 und einen ersten bis dritten Inverter I6, I7, I8 enthält (vgl. Fig. 3);

- eine bistabile Kippstufe MSFF, die als Master-Slave-Kippglied (vgl. Fig 1) ausgebildet ist und einen fünften bis achten Schalter S92, S93, S90, S91 sowie einen vierten bis siebten Inverter I9, I10, I11, I12 enthält (vgl. Fig. 4);

- eine Addiereinheit HA, die als Halbaddierer aufgebaut ist, und logische NAND-Gatter NAND2, NAND3 und ein logisches ODER-Gatter OR2 aufweist, (vgl. Fig. 5);

- eine zweite Speichereinheit RAM (vgl. Fig. 2), die aus Speicherzellen mit wahlfreiem Zugriff $RAMC\emptyset\emptyset$ bis RAMC77 aufgebaut ist, wobei jede Speicherzelle einen neunten bis zwölften Schalter S97, S94, S95, S96 und einen achten und neunten Inverter I13, I14 enthält (vgl. Fig. 6);

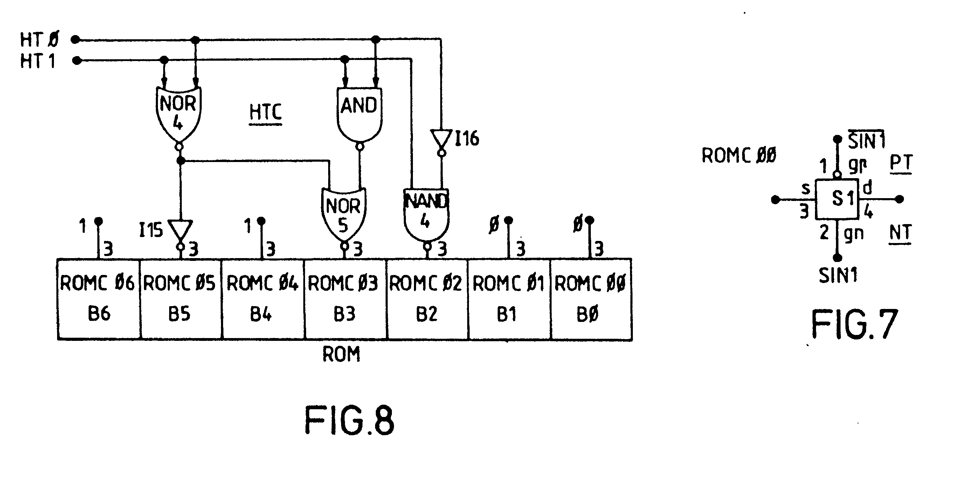

- eine erste Speichereinheit ROM (vgl. Figuren 2, 8), die aus Festwert-Speicherzellen $ROMC\emptyset\emptyset$ bis ROMC76 aufgebaut ist und je einen Schalter S1 enthalten (vgl. Figur 7);

- eine Steuereinheit HTC zum Steuern der ersten Speichereinheit ROM (vgl. Fig. 8), wobei die Steuereinheit aus logischen NOR-Gattern NOR4, NOR5, einem logischen UND-Gatter AND, einem logischen NAND-Gatter NAND4 und aus Invertern I15, I16 aufgebaut ist;

- ein drittes Schaltglied aus einem logischen NAND-Gatter NAND1 und einem logischen ODER-Gatter OR1 (vgl. Figur 1);

- ein viertes Schaltglied aus einem logischen NOR-Gatter NOR2 (vgl. Figur 1);

- logische NOR-Gatter NOR1 und NOR3 (vgl. Figuren 1, 2);

- ein Exklusiv-ODER Gatter EOG (vgl. Figur 1);
- Inverter I1 bis I4 (vgl. Figur 1) und ein Inverter I5 (vgl. Figur 2);
- erste Schaltglieder aus Schaltern S7$\emptyset$ bis S76 (vgl. Figur 2), zweite Schaltglieder aus Schaltern S3$\emptyset$ bis S36 (vgl. Figur 2) und weitere Schalter S4$\emptyset$ bis S47, S5$\emptyset$ bis S57, S6$\emptyset$ bis S67 (vgl. Figur 2) und Schalter S8$\emptyset$ bis S85 (vgl. Figur 1).

Jeder der aufgezählten Schalter entspricht der Bauweise des Schalters S1 in Figur 7 und enthält einen N-Kanal MOSFET NT mit einer Source-Elektrode s oder 3, einer Drain-Elektrode d oder 4 und einer Gate-Elektrode gn oder 2, sowie einen D-Kanal MOSFET PT mit den gleichen Source- und Drain-Elektroden und mit einer Gate-Elektrode gp oder 1.

Um zu zeigen, daß der P-Kanal MOSFET PT und der N-Kanal MOSFET NT durch einen 0-Pegel bzw. einen 1-Pegel an ihren Gate-Elektroden leitend werden, wird der P-Kanal MOSFET mit einem Inverter an seiner Gate-Elektrode gp ausgeführt. Solche übliche Schalter S1 schalten die an der Source-Elektrode 3 anliegende Eingangsspannung zur Drain-Elektrode 4 durch und umgekehrt, wenn an ihre Gate-Elektroden gn, gp ein komplementäres Signal mit 1-Pegel und 0-Pegel, wie z.B. ein Zeitintervallsignal SIN1 und das entsprechend invertierte Zeitintervallsignal $\overline{SIN1}$ , angelegt werden. Dazu sei bemerkt, daß für den Fall, daß der Schalter geschlossen ist, der Eingangszustand an seinem Ausgang auftritt und dadurch die an diesen Ausgängen angeschlossene Leitungskapazitäten geladen oder entladen werden, welches entsprechend vom Eingangspegel 1 oder Pegel 0 abhängt. Diese Ladung bleibt für etwa 2ms erhalten selbst dann, wenn der Schalter geöffnet wird.

Der erste Multiplexer MUX1 enthält Schalter S1$\emptyset$ bis S17 an deren Elektroden 1, 2 und 3 die Zeitintervallsignale $\overline{SIN\emptyset/7}$ , SIN$\emptyset$/7 bzw. das Eingangssignal IN$\emptyset$/7 angelegt werden. Die Drain-Elektroden 4 dieser Schalter S1$\emptyset$/S17 sind gemeinsam an einem ersten Eingang des Exklusiv-ODER Gatters EOG angeschlossen. Dabei besteht die Funktion des ersten Multiplexers MUX1 darin, aufeinanderfolgend die Eingangssignale IN$\emptyset$/7 an den ersten Eingang des Exklusiv-ODER Gatter EOG zu schalten, wobei die Schalter S1$\emptyset$/S17 von den Zeitintervallsignalen SIN$\emptyset$, $\overline{SIN\emptyset}$ bis SIN7, $\overline{SIN7}$ gesteuert werden.

Der zweite Multiplexer MUX2 enthält Schalter S2$\emptyset$/S27 an deren Elektroden 1, 2 und 3 die Zeitintervall-signale $\overline{SIN\emptyset/7}$ , SIN$\emptyset$/7 bzw. das Ausgangssignal der T-Kippglieder TFF$\emptyset$/7 der dritten Speichereinheit MEM angelegt werden. Die Drain-Elektrode 4 dieser Schalter S2$\emptyset$/S27 sind gemeinsam an einen zweiten Eingang des Exklusiv-ODER Gatters EOG angeschlossen, wobei der Ausgang des Exklusiv-ODER Gatters mit einem Dateneingang 1' des Master-Slave-Kippgliedes MSFF verbunden ist. Dabei besteht die Funktion des zweiten Multiplexers MUX2 darin, aufeinanderfolgend die in den T-Kippgliedern TFF$\emptyset$/7 gespeicherte Signale an den zweiten Eingang des Exklusiv-ODER Gatters EOG zu schalten, wobei die Schalter S2$\emptyset$/S27 von den Zeitintervallsignalen SIN$\emptyset$, $\overline{SIN\emptyset}$ bis SIN7, $\overline{SIN7}$ gesteuert werden. Das Exklusiv-ODER Gatter EOG vergleicht nun jedes an seinen Eingängen anliegende Paar von Eingangs- und Ausgangssignalen, wobei für den Fall, daß das anliegende Signalpaar unterschiedliche Werte aufweist eine 1 in das Master-Slave-Kippglied MSFF gespeichert wird.

Da jedes der T-Kippglieder TFF$\emptyset$/7 identisch aufgebaut ist, wird in Figur 3 nur das T-Kippglied TFF$\emptyset$ gezeigt. Es enthält eine erste Schleife aus einer Kaskadenschaltung von dem ersten Inverter I6, dem zweiten Inverter I7, dem dritten Schalter S89, dem dritten Inverter I8, dem ersten Schalter S86 und dem zweten Schalter S87. Ferner weist es Wähleingänge 1' und 2', Dateneingänge 3' und 4', Leseeingänge 5' und 6' und einen Ausgang 7' auf, wobei diese durch die Gate-Elektroden der Schalter S86, S87, S88, S89 bzw. durch den Ausgang des ersten Inverters I6 gebildet werden.

Die Wähleingänge 1' und 2' des ersten Schalters S86 werden durch die Zeitintervallsignale $\overline{SIN1}$ bzw. SIN1 gesteuert; die Dateneingänge 3' und 4' des zweiten Schalters S87 werden durch die Ausgangssignale des Inverters I3 bzw. des vierten Schaltgliedes NOR2 gesteuert (vgl. Figur 1). Die Leseeingänge 5' und 6' werden durch die Lesesignale R bzw. $\overline{R}$ gesteuert, wobei das Lesesignal R in Figur 9 dargestellt ist.

Jedes T-Kippglied TFF$\emptyset$/7 speichert einen vorhergehenden Zustand in den parasitären Eingangskapazitäten des ersten und zweiten Inverters I6, I7. Falls keine neue Daten an seine Dateneingänge 3' und 4' angelegt werden, z.B. wenn die von dem vierten Schaltglied NOR2 und dem Inverter I3 anliegenden Signalpegel $\emptyset$ bzw. 1 sind, ist der zweite Schalter S87 geöffnet, so daß unabhängig ob das T-Kippglied TFF$\emptyset$/7 über seine Wähleingänge 1' und 2' (Schalter S86 geschlossen oder nicht) angesteuert wird oder nicht, dieser vorhergehende Zustand in der ersten Schleife für jedes Lesesignal R und $\overline{R}$ vorliegt. Für diesen Fall wird der gespeicherte vorhergehende Zustand nicht abgeändert.

Falls nun neue Daten an die Dateneingänge 3' und 4' des T-Kippgliedes TFF$\emptyset$ angelegt werden, d.h. ein 0-Pegel und 1-Pegel an dem Dateneingang 3' und 4', und falls das T-Kippglied TFF$\emptyset$ durch die Zeitintervallsignale SIN1, $\overline{SIN1}$ angesteuert werden, sind die beiden Schalter S87 und S86 geschlossen. Der vorhergehende Zustand liegt dann am Ausgang der ersten Schleife, d.h. am Verbindungspunkt des zweiten Inverters I7 und des vierten Schalters S88 an, wird dann an den Eingang dieser Schleife am Verbindungs-

EP 0 146 938 B1

punkt des ersten Inverters I6 und des zweiten Schalters S87 über den dritten Schalter S89, den dritten Inverter I8, den ersten Schalter S86 und den zweiten Schalter S87 mit dem Eintreffen von dem Lesesignal R geschaltet, wobei das Lesesignal $\overline{R}$ den dritten Schalter S89 schließt. Dabei wird der vorhergehende Zustand durch den dritten Inverter I8 invertiert und in der ersten Schleife gespeichert, in der er dann anliegt. Somit wurde das T-Kippglied in einem neuen Zustand geschaltet.

Das Master-Slave-Kippglied ist detailiert in Figur 4 gezeigt und enthält eine Kaskadenschaltung aus dem siebten Schalter S90, dem vierten und fünften Inverter I9, I10, dem achten Schalter S91 und dem sechsten und siebten Inverter I11, I12, wobei die Inverter I9, I10 und der Schalter S92 als Slave-Schleife und die Inverter I11, I12 und der Schalter S93 als Master-Schleife geschaltet sind. Das Master-Slave-Kippglied MSFF weist einen Eingang 1', einen Ausgang 2' oder $\overline{Q}$ und Steuereingänge 3', 4' und Steuereingänge 5', 6' auf, die durch die Source-Elektrode des Schalters S9∅, den Ausgang des Inverters I11 und den Gate-Elektroden der Schalter S9∅, S93 und den Sc haltern S91, S92 gebildet werden.

Der Eingang 1' ist mit dem Ausgang des Exklusiv-ODER-Gatters EOG verbunden; der Ausgang 2' oder $\overline{Q}$ ist an den Eingang des ODER-Gatters OR1 (vgl. Figur 1) und an den Eingang des NOR-Gatters NOR3 (vgl. Figur 2) geführt; die Steuereingänge 3', 4' und die Steuereingänge 5', 6' werden durch die Signalverläufe eines vierten Steuersignales A, $\overline{A}$ und eines fünften Steuersignales B, $\overline{B}$ gesteuert. Diese Signalverläufe der Steuersignale A, B, wie in Figur 9 gezeigt, werden durch eine Einheit aus dem NOR-Gatter NOR1, den Schaltern S80, S81 und den Invertern I1, I2 erzeugt (vgl. Figur 1). Die Bittaktsignale SB∅ und SB7 werden an die gleichbenannten Eingänge des NOR-Gatters NOR1 angelegt, wobei der Ausgang des NOR-Gatters NOR1 mit der Source-Elektrode 3 des Schalters S8∅ verbunden ist. Das Bittaktsignal SB7 wird außerdem an die Source-Elektrode 3 des Schalters S81 angelegt. Die Schalter S8∅ und S81 werden durch das Lesesignal R, $\overline{R}$ bzw. das Schreibsignal W, $\overline{W}$ gesteuert und stellen an ihren Ausgängen die Signalverläufe der Steuersignale A bzw. B zur Verfügung, während an den Ausgängen der Inverter I1 und I2 die invertierten Steuersignale $\overline{A}$ bzw. $\overline{B}$ anliegen, wobei die Eingänge der Inverter I1 und I2 an die Drain-Elektrode 4 der Schalter S8∅ bzw. S81 angeschlossen sind. Theoretisch ergibt sich das Steuersignal A in der Form A = $\overline{SB∅}$ $\overline{+}$ $\overline{SB7}$` $\overline{R}$ und das Steuersignal B in der Form B = SB7` W, jedoch in der Praxis, wie auch in Figur 9 gezeigt, sind die Impulsflanken der Steuersignale A und B in Bezug zu dem Signal der Form $\overline{SB∅}$ $\overline{+}$ $\overline{SB7}$ bzw. dem Signal der Form SB7 etwas verzögert, da eine gewisse Zeit notwendig ist, um die Leitungskapazitäten an den Ausgängen der Schalter S8∅ bzw. S81 zu laden bzw. zu entladen. Daüberhinaus verbleiben die Ausgänge der Schalter S8∅ und S81 entsprechend der Leistungskapazitäten auf 0-Pegel bzw. 1-Pegel, solange die Signale der Form $\overline{SB∅}$ $\overline{+}$ $\overline{SB7}$ und SB7 einen 0-Pegel bzw. 1-Pegel aufweisen, wobei jedoch die Stellung der Schalter S8∅ und S81 sich entsprechend dem Verlauf des zuletzt genannten Signales ändern (vgl. Figur 9).

Jedesmal, wenn die Signalform des Steuersignales A einen 1-Pegel aufweist sind die Schalter S9∅ und S93 geschlossen, so daß gleichzeitig der Zustand eines Signales am Eingang 1' des Master-Slave-Kippgliedes MSFF an den Eingang der Slave-Schleife angelegt und in der Eingangskapazität der Inverter I9, I10 abgespeichert wird und daß der in der Eingangskapazität der Inverter I11, I12 gespeicherte Zustand in der Master-Schleife umläuft.

Jedesmal, wenn die Signalform des Steuersignales B einen 1-Pegel aufweist sind die Schalter S91· und S92 geschlossen, so daß gleichzeitig der in der Slave-Schleife gespeicherte Zustand in dieser Schleife umläuft und an die Master-Schleife angelegt wird, in der dieser Zustand nach Erreichen des 1-Pegels des Steuersignales A gespeichert wird und somit umläuft. Dies bedeutet, daß das in der Slave-Schleife gespeicherte Signal an Ausgang 2' oder $\overline{Q}$ des Master-Slave-Kippgliedes MSFF anliegt, wenn die Vorderflanke des Steuersignales B den 1-Pegel erreicht (vgl. Figur 9).

Die als Halbaddierer ausgeführte Addiereinheit HA wird in Figur 5 detailliert gezeigt. Sie weist einen ersten Addiereingang A1 und einen zweiten Addiereingang A2, einen invertierten Summenausgang $\overline{S}$ und einen invertierten Übertragausgang $\overline{C}$ auf. Die Addiereinheit HA enthält logische NAND-Gatter NAND2, NAND3 und ein ODER-Gatter OR2. Die Addiereingänge A1 und A2 sind mit den Eingängen des NAND-Gatters NAND2 und des ODER Gatters OR2 verbunden, wobei am Ausgang des NAND-Gatter NAND2 das inverse Übertragungssignal $\overline{C}$ abgreifbar ist. Dieses Übertragsignal $\overline{C}$ und das Ausgangssignal des ODER-Gatters OR2 sind an die Eingänge des NAND-Gatters NAND3 angelegt, wobei der Ausgang des NAND-Gatters NAND3 das inverse Summensignal $\overline{S}$ zur Verfügung stellt. Das inverse Summensignal $\overline{S}$ und das inverse Übertragsignal $\overline{C}$ sind durch die folgenden booleschen Ausdrücke gekennzeichnet:

5

EP 0 146 938 B1

$$\overline{S} = \overline{\overline{A1} + \overline{A2}} + C$$

$$\overline{C} = \overline{\overline{A1} \cdot \overline{A2}}$$

Daraus ergibt sich die folgende Wahrheitstabelle:

| A1 | A2 | S | C |
|----|----|---|---|
| 0  | 0  | 0 | 0 |
| 0  | 1  | 1 | 0 |
| 1  | 0  | 1 | 0 |
| 1  | 1  | 0 | 1 |

Der erste Addiereingang A1 ist an die verbundenen Drain-Elektroden 4 der Schalter S6∅ bis S67 (vgl. Figur 2) angeschlossen. Der zweite Addiereingang A2 ist über den durch das Lesesignal R, R̄ gesteuerten Schalter S83 mit dem Ausgang 2' des Master-Slave-Kippgliedes MSFF, der über die Reihenschaltung aus dem ODER-Gatter OR1 und dem NAND-Gatter NAND1 an den Schalter S83 geführt ist, verbunden. Dabei sind die Eingänge des ODER-Gatters OR1 also mit den Ausgang 2' oder Q̄ des Master-Slave-Kippgliedes MSFF und mit dem Bittaktsignal S̄8∅ verbunden. Der Ausgang des ODER-Gatters OR1 ist an ein Eingang des NAND-Gatters NAND1 angeschlossen und dessen anderer Eingang ist über den durch das Schreibsignal W, W̄ gesteuerte Schalter S82 mit dem invertierten Übertragausgang C̄ der Addiereinheit HA verbunden. Wenn man das Signal an Ausgang 2' des Master-Slave-Kippgliedes mit Q̄ bezeichnet, so hat das Signal am zweiten Addiereingang A2 die Form

A2 = C + Q • SB∅

Die Drain-Ekektrode 4 des Schalters S82 ist an einen Eingang des NOR-Gatters NOR2 angeschlossen, dessen andere Eingänge durch das Bittaktsignal S̄B̄6 und das Schreibsignal W̄ gesteuert werden. Somit kann das an die verbundenen Eingänge 4 der T-Kippglieder TFF∅ bis TFF7 angelegte Ausgangssignal des NOR-Gatters NOR2 wie folgt dargestellt werden:

NOR2 = C • W • SB6.

Die zweite Speichereinheit RAM (vgl. Figur 2) enthält acht Reihen aus 8 Speicherzellen RAMC∅∅/∅7 bis RAMC7∅/77, die den Eingängen IN∅ bis IN7 des Signalerkennungssystems zugecrdnet sind und durch die Zeitintervallsignale SIN1, S̄I̅N̅1̅ bis SIN∅, S̄I̅N̅∅̅ angesteuert werden. Dabei werden in den ersten 7 Speicherzellen jeder der 8 Reihen von Speicherzellen Werte abgespeichert, die den Zeiteinheiten entsprechen die noch ablaufen müssen bis das entsprechende Eingangssignal vollständig entprellt ist, wohingegen die achte Speicherzelle in jeder der 8 Reihen von Speicherzellen zum Abspeichern eines sogenannten Überlaufbits mit 1-Pegel für den Fall vorgesehen ist, daß alle anderen Speicherzellen einer Reihe einen 0-Pegel beinhalten. Da jeder dieser Speicherzellen identisch aufgebaut ist, wird in Figur 6 nur eine Speicherzelle RAMC∅∅ gezeigt. Sie besteht aus der Kaskandenschaltung der Schalter S94, S95, den Invertern I13, I14 und dem Schalter S96, wobei die Inverter I13, I14 und der Schalter S97 als Schleife geschaltet sind. Die Speicherzelle RAMC∅∅ weist Wähleingänge 1', 2', einen Dateneingang 3', einen Datenausgang 4' und Steuereingänge 5', 6' und 7', 8' auf, die entsprechend durch die Gate-Elektroden der Schalter S95, S96, durch die Source-Elektrode des Schalters S94, durch die Drain-Elektrode des Schalters S96 und den Gate-Elektroden der Schalter S97, S94 gebildet werden. Die Wähleingänge 1' und 2' werden durch die Zeitintervallsignale SIN1 bzw. S̄I̅N̅1̅ gesteuert; die Steuereingänge 5' und 6' werden durch das Lesesignal R bzw. R̄ gesteuert; und die Steuereingänge 7' und 8' werden durch das Schreibsignal W bzw. W̄ gesteuert.

Falls eine Speicherzelle nicht angesteuert wird, sind die Schalter S95 und S96 geöffnet, wobei der Zustand des in den paraistären Kapazitäten der Inverter I13, I14 gespeicherten Signales immer dann in der Schleife aus den Invertern I13, I14 und dem Schalter S97 umläuft, wenn der Schalter S97 durch ein 1-Pegel des Lesesignales R geschlossen ist. Wenn nun die Speicherzelle angesteuert wird, d.h. wenn die Schalter S95 und S96 geschlossen sind, liegt der in der Speicherzelle gespeicherte Zustand dann über den Schalter S96 am Ausgang 4' an, wenn der umlaufende Zustand über den durch das Lesesignal R aktivierte Schalter

6

S97 gelangt. Außerdem wird durch das Ansteuern der Speicherzelle ein am Eingang 3' anliegender Zustand über die durch das Schreibsignal W und das Zeitintervallsignal SIN1 aktivierten Schalter S94 bzw. S95 abgespeichert.

Die das zweite Schaltglied S3∅/S36 darstellenden sogenannten Ausgangsschalter S3∅ bis S36, die Schalter S4∅ bis S46 zum Regenerieren der Daten und die sogenannten Eingangsschalter S5∅ bis S56 der zweiten Speichereinheit RAM, sowie die gemeinsamen Ausgangsschalter S6∅ bis S66 der ersten und der zweiten Speichereinheit ROM, RAM sind entsprechend den Spalten aus den Speicherzellen RAMC∅∅/7∅ bis RAMC∅6/76 zugeordnet. Ferner ist der Schalter S47 zum Regenerieren der Daten und der Eingangsschalter S57 der zweiten Speichereinheit RAM der Spalte aus den Speicherzellen RAMC∅7/77 zugeordnet. Ein logischer 1-Pegel wird fortwährend an den Eingang 3 eines weiteren der ersten und zweiten Speichereinheiten ROM, RAM gemeinsamen Ausgangsschalters S67 angelegt.

Die Eingänge 1 und 2 der Schalter S3∅/36 werden durch die Signale $\overline{\text{NOR3}}$ und NOR3 = Q . $\overline{\text{P}}$ gesteuert, wobei die Signale an den Ausgängen des Inverters I5 bzw. des NOR-Gatters NOR3 erzeugt werden.

Die Eingänge des NOR-Gatters NOR3 sind an den Ausgang 2' oder $\overline{\text{Q}}$ der bistabilen Kippstufe MSFF und an den Ausgang P oder 4 der Spalte aus den Speicherzellen RAMC∅7/77 der zweiten Speichereinheit RAM angeschlossen.

Die Eingänge 1 und 2 der Schalter S4∅/47, S5∅/57 und S6∅/67 werden durch die Bittaktsignale SB∅/7 und SB∅/7 angesteuert. Die gemeinsamen Drain-Elektroden 4 der Speicherzellen in den Spalten RAMC∅∅/7∅ bis RAMC ∅6/76 der zweiten Speichereinheit RAM sind über eine Kaskadenschaltung aus den Schaltern S3∅ bis S36, S6∅ bis S66 und S85 an den ersten Addiereingang A1 der Addiereinheit HA angeschlossen, wobei der Schalter S85 durch das Lesesignal R und $\overline{\text{R}}$ gesteuert wird und wobei die Ausgänge 4 dieser Speicherzellen in den Spalten RAMC∅∅/7∅ bis RAMC∅7/77 der zweiten Speichereinheit RAM zu den Eingängen 3 dieser Speicherzellen über die Schalter S4∅ bis S47 zurückgekoppelt sind. Der invertierte Summenausgang $\overline{\text{S}}$ der Addiereinheit HA ist an die Eingänge 3 der Speicherzellen in den Spalten RAMC∅∅/7∅ bis RAMC∅7/77 über den durch das Schreibsignal W, $\overline{\text{W}}$ gesteuerten Schalter S84, über den Inverter I4 und über die Schalter S5∅ bis S57 angeschlossen.

Die erste Speichereinheit ROM (vgl. Figuren 3 und 8) enthält 8 Reihen aus jeweils 7 Speicherzellen ROMC∅∅/76 bis ROMC7∅/76, die den Signaleingängen IN∅ bis IN7 des Signalerkennungssystems zugeordnet sind. Da jede dieser Speicherzellen vom gleichen Typ ist, wird in Figur 7 nur die Speicherzelle ROMC∅∅ gezeigt. Sie ist aus einem Schalter S1 aufgebaut, der Steuereingänge 1, 2 einen Eingang 3 und einen Ausgang 4 aufweist, wobei die Steuereingänge 1, 2 durch die Zeitintervallsignale $\overline{\text{SIN1}}$ , SIN1 angesteuert werden. Die 8 Reihen können mittels der Zeitintervallsignale SIN1, $\overline{\text{SIN1}}$ bis SIN∅, $\overline{\text{SIN∅}}$ angesteuert werden, wobei in ihnen Werte entsprechend der Zeit die notwendig ist die Eingangssignale zu entprellen, abgespeichert werden. Da jede Reihe 7 Bit enthält, kann entsprechend ein Wert X zwischen ∅ und 127 abgespeichert werden. Da eine entsprechende Reihe der zweiten Speichereinheit RAM alle 2 Millisekunden abgetastet wird, entsprircht dieser Wert X einer Zeitdauer von 2 mal X Millisekunden. Damit eine Addition anstelle einer Subtraktion erreicht wird, wird das Komplement zu 127 des Entprellwertes abgespeichert. Bezeichnet man die Bits einer jeden Reihe mit B∅ bis B6 (B∅ = niedrigstwertiges Bit, B6 = höchstwertiges Bit), so ergibt sich der Inhalt der ersten Speichereinheit wie folgt:

| Reihe | B6 | B5 | B4 | B3 | B2 | B1 | BØ | Wert | Zeit (ms) |
|-------|----|----|----|----|----|----|----|------|-----------|
| Ø | 1 | Ø | 1 | Ø | 1 | Ø | Ø | 84 | 88 |
|   | 1 | 1 | 1 | 1 | Ø | Ø | Ø | 120 | 16 |
|   | 1 | 1 | 1 | 1 | 1 | Ø | Ø | 124 | 8 |
|   | 1 | 1 | 1 | Ø | 1 | Ø | Ø | 116 | 24 |
| 1 | 1 | 1 | Ø | 1 | 1 | Ø | Ø | 108 | 70 |
| 2 | 1 | 1 | 1 | 1 | 1 | Ø | Ø | 124 | 8 |
| 3 | Ø | 1 | 1 | Ø | 1 | Ø | 1 | 53 | 150 |
| 4 | 1 | 1 | 1 | 1 | 1 | Ø | Ø | 124 | 8 |
| 5 | 1 | 1 | 1 | 1 | 1 | Ø | Ø | 124 | 8 |
| 6 | 1 | 1 | 1 | 1 | 1 | Ø | Ø | 124 | 8 |
| 7 | 1 | 1 | 1 | 1 | 1 | Ø | Ø | 124 | 8 |

Es wird ein "0"-Wert oder ein "1"-Wert in jeder Speicher zelle abgespeichert, falls am Eingang 3 ein "0"-Wert bzw. ein "1"-Wert anliegt. Der Zeitwert in Millisekunden in der letzten Spalte wird durch die Bildung des Komplements zu 127 aus dem Wert in der vorletzten Spalte, durch anschließende Addition von 1 und durch Multiplikation der erhaltenen Summe mit 2 erreicht.

In Bezug auf die obige Tabelle sei gesagt, daß der Inhalt der Reihen 1 bis 7 fest sind, wohingegen der Inhalt der Reihe Ø durch die Steuereinheit HTC (vgl. Figur 8 geändert werden kann. Dabei wird die Steuereinheit HTC durch mit HTØ und HT1 bezeichnete Bits, die von einer nicht näher gezeigten Steuereinheit gesendet werden, gesteuert. Die Steuereinheit HTC enthält das UND-Gatter AND, die NOR-Gatter NOR4, NOR5 und das NAND-Gatter NAND4 sowie die Inverter I15 und I16. Diese sind, wie in Figur 8 gezeigt, so verschaltet, daß an den Ausgängen des NAND-Gatters NAND4, des NOR-Gatters NOR5 und des Inverters I15 die folgenden Signale auftreten:

$$NAND4 = HT\emptyset + \overline{HT1}$$
$$NOR5 = HT\emptyset \bullet \overline{HT1} + \overline{HT\emptyset} \bullet HT1$$
$$I15 = HT\emptyset + HT1$$

Diese Signale werden an die Eingänge 3 der Speicherzellen ROMCØ2, ROMCØ3 und ROMCØ5 der ersten Speichereinheit ROM angelegt, während die Eingänge 3 der Speicherzellen ROMCØØ und ROMCØ1 und die Eingänge der Speicherzellen ROMCØ4 und ROMCØ6 an einen logischen "0"-Wert bzw. einen logischen "1"-Wert geführt werden.

Die das erste Schaltglied S7Ø/S76 darstellenden sogenannten Ausgangsschalter S7Ø bis S76 und die für die erste und zweite Speichereinheit ROM, RAM gemeinsamen Ausgangsschalter S6Ø bis S66 sind den Spalten mit den Speicherzellen ROMCØØ/7Ø bis ROMCØ6/76 zugeordnet. Die gemeinsamen Eingänge 1 und 2 der Schalter S7Ø bis S76 sind mit den Eingängen 2 bzw. 1 der Schalter S3Ø bis S36 verbunden und die gemeinsamen Ausgänge 4 der Speicherzelle der Spalten ROMCØØ/Ø7 bis ROMCØ6/76 der ersten Speichereinheit ROM sind über die Kaskadenschaltung aus den Schaltern S7Ø bis S76, den Schaltern S6Ø bis S67 und dem Schalter S85 an den ersten Addiereingang A1 der Addiereinheit HA angeschlossen.

Die Funktionsweise des Signalerkennungs- oder Entprellsystems wird nun im folgenden detailliert beschrieben.

Aus dem zuvor Erläuterten und aus Figur 9 ist zu entnehmen, daß jedes der Zeitintervallsignale SINØ bis SIN7 8 Bittaktsignale SBØ bis SB7 enthält und daß jedes dieser Bittaktsignale SBØ/7 vor der ansteigenden Vorderflanke eines Lesesignales R beginnt und nach der abfallenden Rückflanke eines Schreibsignales W endet, dem sofort das Lesesignal R folgt.

Da alle 8 Eingangssignale auf die gleiche Art und Weise verarbeitet werden, wird nur das Eingangssignal INØ näher betrachtet. Das Eingangssignal INØ wird an den gleichbenannten Signaleingang INØ während jedem Zeitintervallsignal SINØ mit einer Periode von 2ms angelegt. Der binäre in den Speicherzellen ROMCØ6 bis ROMCØØ der ersten Speichereinheit ROM abgespeicherte Entprellwert, der dem Eingangssignal INØ zugeordnet ist, wird zu 11111ØØ angenommen, während der abgespeicherte Binärwert in den Speicherzellen RAMCØ7 bis RAMCØØ der zweiten Speichereinheit RAM, der ebenfalls dem Eingangssignal INØ zugeordnet ist, als beliebig angenommen wird. Der oben angegebene binäre Entprellwert entspricht dem Dezimalwert 124 und einer Entprellzeit von 8 ms (vgl. auch zuvor angegebene Tabelle).

Es wird zunächst angenommen, daß das in der Speicherzelle RAMCØ7 gespeicherte Übertragbit gleich 0 ist, so daß das Ausgangssignal P an den angeschlossenen Ausgängen 4 der Speicherzelle RAMCØ7/77 während jedem Zeitintervall, in dem das Eingangssignal INØ verarbeitet wird, auf einen 0 -Pegel liegt. Daraus folgend ist das Ausgangssignal Q • $\overline{P}$ des NOR-Gatters NOR3 (vgl. Figur 2) gleich dem Signal Q, so daß die Ausgangsschalter S3Ø bis S36 oder S7Ø bis S76 entweder geschlossen oder geöffnet sind, falls das Signal Q einen 1 -Pegel bzw. 0 -Pegel aufweist.

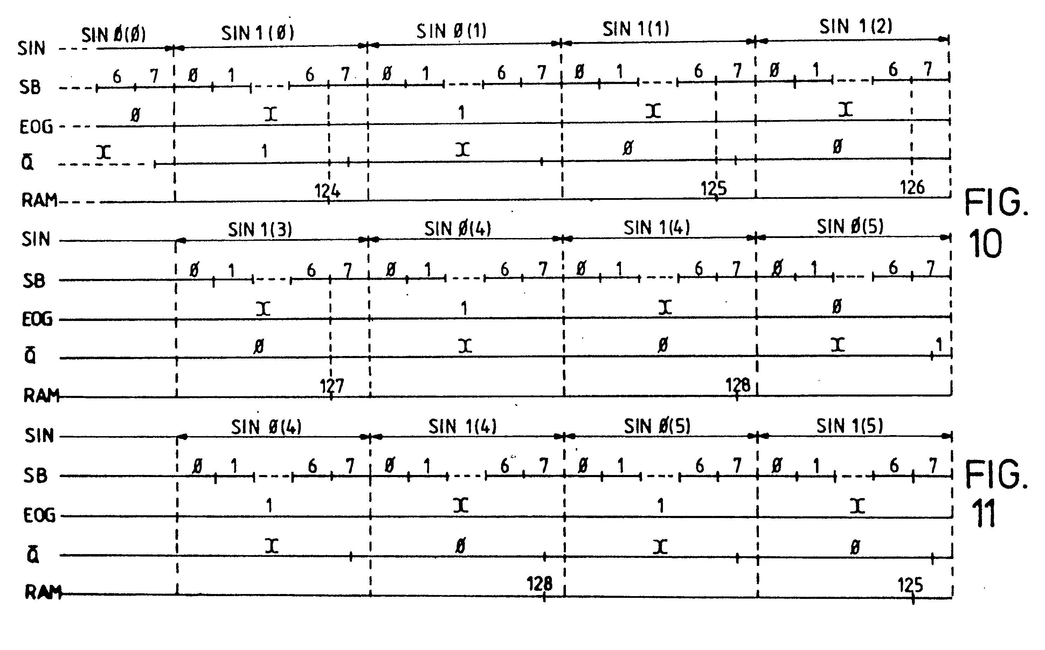

Das Eingangssignal INØ und nur dieses Eingangssignal wird nun, wie Figur 10 zeigt, für eine Vielzahl von Zeitintervallen, die mit SINØ(Ø), SIN1(Ø), SINØ(1), SIN1(1), SIN1(2), SIN1(3), SINØ(4), SIN1(4) und SINØ(5) bezeichnet und benachbart zueinander sind, betrachtet, obwohl die Periode des Zeitintervallsignales SINØ, sowie die des Zeitintervallsignales SIN1 gleich 2 ms beträgt. In Figur 10 bezeichnet X den Zustand "ohne Bedeutung", d.h. es ist egal ob der Zustand 1 oder 0 angenommen wird.

SINØ(Ø),      d.h. ein erstes Zeitintervallsignal SINØ

SBØ bis SB6:      der momentane und der vorhergehende Zustand des Eingangssignales INØ werden in dem Exklusiv-ODER Gatter EOG verglichen und es wird angenommen, daß die Zustände gleich sind, wodurch das Ausgangssignal des Exklusiv-ODER Gatters EOG einen 0 -Pegel annimmt;

SB7:      am Ende dieses Bittaktsignales, an dem das Steuersignal B den Pegel 1 annimmt, wird das Ausgangssignal des Exklusiv-ODER-Gatters EOG mit dem 0 -Pegel in die bistabile Kippstufe MSFF eingeschrieben, so daß deren Ausgang 2' oder $\overline{Q}$ zu 1 wird oder auf 1 verbleibt. Daraus folgend sind die Ausgangsschalter S3Ø bis S36 und die Ausgangsschalter S7Ø bis S76 geöffnet bzw. geschlossen;

SIN1(Ø),      d.h. ein erstes Zeitintervallsignal SIN1

SBØ:      - wenn der Schreibimpuls R kurz nach dem Start des Bittaktsignales SBØ (vgl. Figur 9)

9

zu 1 wird:

= das in der Speicherzelle RAMC00 gespeicherte Bit (durch das Zeitintervallsignal SIN1 angesteuert) wird ausgelesen und wieder in dieser Speicherzelle über den Schalter S40 abgespeichert (angesteuert durch das Bittaktsignal SB0). Diese erneute Abspeicherung ist notwendig, da die Zeit in der die Daten in einer Speicherzelle der zweiten Speichereinheit RAM abgespeichert sind ungefähr gleich der Abtastperiode der Speicherzellen von 2ms ist;

= das in der Speicherzelle ROMC00 (durch SIN1 angesteuert) gespeicherte Bit 0 wird an den ersten Addiereingang A1 der Addiereinheit HA über den ROM-Ausgangsschalter S70 (angesteuert durch NOR3), über den RAM/ROM-Ausgangsschalter S60 (angesteuert durch SB0) und über den Schalter S85 (geschlossen durch R = 1) angelegt;

= das Bit $C + Q \cdot SB0$, das an dem zweiten Addiereingang A2 über OR1, NAND1, S83 anliegt ist gleich 0, da das vorhergehende Übertragsignal C = 0, Q = 0 und SB0 = 1 sind. Da A1 = A2 = 0 sind, ergibt sich der Summenausgang $\overline{S}$ = 1 und $\overline{C}$ = 1.

-- wenn das Schreibsignal W zu 1 wird, am Ende des Bittaktsignales SB0 (vgl. Figur 9):

= das neue Übertragsignal $\overline{C}$ = 1 wird über S82 (geschlossen durch W = 1) an das NAND-Gatter NAND1 angelegt, um für die folgende Addition und am NOR-Gatter NOR2 zur Verfügung zu stehen. Das Ausgangssignal

C · W · SB6 dieses NOR-Gatters NOR2 ist $\emptyset$
da   SB6 = $\emptyset$ ist;

= das Summensignal $\cdot \overline{S}$ = 1 wird über den
Schalter S84 (geschlossen durch W = 1),
den Inverter I4 und den Eingangsschalter
S5$\emptyset$ (angesteuert . durch SB$\emptyset$) an die
Speicherzelle RAMC$\emptyset\emptyset$ angelegt, so daß
S = $\emptyset$ in diese Speicherzelle geschrieben wird.

Daraus folgt, daß während des Bittaktsignales SB$\emptyset$ des Zeitintervallsignales SIN$\emptyset$ eine $\emptyset$ zu dem Bit $\emptyset$ in der Speicherzelle ROMC$\emptyset\emptyset$ addiert und die Summe $\emptyset$ in der Speicherzelle RAMC$\emptyset\emptyset$ abgespeichert wurde. D.h. das in der Speicherzelle ROMC$\emptyset\emptyset$ gespeicherte Bit wurde in die Speicherzelle RAMC$\emptyset\emptyset$ kopiert.

SB1_bis_SB6:        hier läuft der gleiche Vorgang ab, so daß
am Ende des Bittaktsignales SB6 der Inhalt
der Reihe von Speicherzellen RAMC$\emptyset$6 bis
RAMC$\emptyset\emptyset$ gelich   1 1 1 1 $\emptyset$ $\emptyset$ oder 124
beträgt (vgl. erste Reihe in Figur 10).

SB7:        Während diesem Bittaktsignal läuft ein
ähnlicher Vorgang wie zuvor ab, wobei jetzt
ein festes Bit $\emptyset$ anstelle eines in einer
ROM-Speicherzelle gespeicherten Bits an den
ersten Addiereingang A2 der Addiereinheit
HA über den Schalter S67 angelegt wird und
wobei die Summe S = $\emptyset$ von diesem Bit und
das vorherige Übertragbit C = $\emptyset$ als Übertragbit in der Speicherzelle RAMC$\emptyset$7 abgespeichert wird. Demzufolge ist der Inhalt
der Speicherzelle RAMC$\emptyset$7 bis RAMC$\emptyset\emptyset$ der

Reihe Ø der zweiten Speichereinheit RAM
gleich  Ø 1 1 1 1 1 Ø Ø.
Da während des letzten Additionsvorgangs
der erste Addiereingang A1 immer Ø war, ist
das zuletztgenannte neue Übertragbit, das
während dem Bittaktsignal SB7 erzeugt wurde,
immer Ø. Aus diesem Grund war C gleich Ø
während dem oben betrachteten Bittaktsignal
SBØ.

SINØ(1),          d.h. ein zweites Zeitintervallsignal SINØ

SBØ_bis_SB7:      der momentane und der vorausgehende Zustand
                  des Eingangssignals INØ wird durch das Ex-
                  klusiv-ODER Gatter EOG verglichen und es
                  wird angenommen, daß das Ausgangssignal
                  des EOG jetzt 1 ist;

SB7:              die 1 am Ausgang des EOG wird in die bi-
                  stabile Kippstufe MSFF eingeschrieben, so
                  daß deren Ausgang $\overline{Q}$ zu Ø wird. Daraus
                  folgend sind die Ausgangsschalter S3Ø bis
                  S36 und S7Ø bis S76 geschlossen bzw. ge-
                  öffnet.

SIN1(1),          d.h. ein zweites Zeitintervall SIN1

SBØ:           -- wenn das Lesesignal R zu 1 wird:
               =  das in RAMCØØ gespeicherte Bit Ø wird
                  einerseits ausgelesen und dann wieder über
                  S4Ø in dieser Speicherzelle abgespeichert
                  und wird andererseits an den ersten Addier-
                  eingang A1 der Addiereinheit HA über die
                  Schalter S3Ø, S6Ø und S85 angelegt;

12

= das Bit C + Q · SBØ wird über die Gatter OR1, NAND1 und den Schalter S83 an den zweiten Addiereingang A2 angelegt. Da C = Ø, Q = 1 und SBØ = 1 sind liegt am zweiten Addiereingang A2 eine 1 und da A1 = Ø ist sind S = 1 und C = Ø oder $\overline{S}$ = Ø und $\overline{C}$ = 1;

-- wenn das Schreibsignal W zu 1 wird:

= $\overline{C}$ = 1 wird über den Schalter S82 und das Gatter NAND1 für den folgenden Additions-vorgang angelegt;

= S = 1 wird in die Speicherzelle RAMCØØ über den Schalter S84, den Inverter I4 und den Schalter S50 eingeschrieben.

Es wird also während dem Bittaktsignal SBØ eine 1 zu dem in der Speicherzelle RAMCØØ abgespeicherten Bit Ø addiert und der resultierende Summenwert wird dann in der Speicherzelle RAMCØØ abgespeichert.

SB1_bis_SB7:    Zur Q = Ø sind die Vorgänge während dieser Bittaktsignale entsprechend wie zuvor, da alle aufeinanderfolgenden Übertragbits Ø sind. Am Ende des Zeitintervallsignals SINØ(2) enthalten die Speicherzellen RAMCØ7 bis RAMCØØ den Wert Ø 1 1 1 1 Ø 1 oder 125 (vgl. RAM in Figur 10).

Dies bedeutet, daß unter Zuhilfenahme der Addiereinheit HA eine 1 seriell zu den in diesen Speicherzellen gespeicherten kom-

EP 0 146 938 B1

plementären Entprellwert addiert wurde.

SIN1(2), d.h. ein drittes Zeitintervallsignal SIN1

Der in der Reihe 0 der zweiten Speichereinheit RAM gespeicherte Wert wird zu
0 1 1 1 1 1 1 0 oder 126 geändert.

SIN1(3), d.h. ein viertes Zeitintervallsignal SIN1

Dieser Wert wird zu
0 1 1 1 1 1 1 1 oder 127 geändert.

SIN0(4), d.h. ein fünftes Zeitintervallsignal SIN0

Hiermit soll gezeigt werden, daß der Ausgang des Exklusiv-ODER Gatters EOG noch auf 1 ist.

SIN1(4), d.h. ein fünftes Zeitintervallsignal SIN1

SB0 bis SB5: Die in den Speicherzellen RAMC00 bis RAMC05 abgespeicherten Bits werden alle zu 0 geändert.

SB6: -- Das in der Speicherzelle RAMC06 gespeicherte Bit wird auch zu 0 geändert. Das in dieser Speicherzelle gespeicherte Bit 1 wird an den ersten Addiereingang A1 und das Signal $C + Q \cdot SB0 = 1$ an den zweiten Addiereingang A2 der Addiereinheit HA angelegt. Das Signal $C + Q \cdot SB0 = 1$, da $C = 1$ aufgrund einer während SB5 zu einer 1 addierten 1 und da $SB0 = 0$ ist. Daraus

14

folgend wird $\overline{S}$ = 1 und $\overline{C}$ = 0, so daß S = 0 in der Speicherzelle RAMC06 abgespeichert und $\overline{C}$ = 0 über den Schalter S82 an die Gatter NAND1 und NOR2 angelegt wird. Der Inhalt der Speicherzellen RAMC06 bis RAMC00 wird dann zu

0 0 0 0 0 0 0 ,

wodurch angezeigt wird, daß ein Zeitinterval entsprechend dem Entprellzeitintervall von 8ms seit dem Abspeichern eines neuen Zustandes des Eingangssignals IN0 in der bistabilen Kippstufe MSFF am Ende des Zeitintervallsignals SIN0(1) vergangen ist.
-- Das Ausgangssignal C · W · SB6 des Gatters NOR2 wird 1, falls W = 1 ist, so daß das T-Kippglied TFF0 in einen neuen Zustand geschaltet wird. Somit ist der neue Zustand des Eingangssignals IN0 als richtig erkannt und abgespeichert.

SB7: Während diesem Bittaktsignal wird das an den Schalter S67 fortwährend anliegende Bit 0 an den ersten Addiereingang A1 der Addiereinheit HA übertragen, an dessen zweiten Addiereingang A2 das Signal C + Q · SB0 angelegt wird. Darausfolgend wird $\overline{S}$ = 0 und $\overline{C}$ = 1, so daß S = 1 in der Speicherzelle RAMC07 als Übertragbit gespeichert und $\overline{C}$ = 1 über den Schalter S82 an das Gatter NAND1 angelegt wird. Der Inhalt der Speicherzellen RAMC07 bis RAMC00 ist von jetzt an gleich

1 0 0 0 0 0 0 0  oder 128.

Dadurch wird die Tatsache, daß ein Entprellvorgang beendet ist in der Speicher-

zelle RAMC07 abgespeichert. Demzufolge
wird das Ausgangssignal Q · $\overline{P}$ des Gatters
NOR3 zu 0, so daß die Ausgangsschalter
S30 bis S36 und S70 bis S76 nun geöffnet
bzw. geschlossen sind.


SIN0(5),          d.h. ein sechstes Zeitintervallsignal SIN0

Da das T-Kippglied TFF0 in einen neuen Zustand geschaltet wurde, wird der Ausgang
des Exklusiv-ODER Gatters EOG gleich 0 und
während dem Bittaktsignal SB7 wird der
Ausgang der bistabilen Kippstufe MSFF,
genau wie während dem Zeitintervallsignal
SIN0(0), zu 1.


SIN1(5),          d.h. ein sechstes Zeitintervallsignal SIN1


Der Inhalt 124 der ersten Speichereinheit
ROM wird, genau wie während dem Zeitintervallsignal SIN1(0), in der zweiten Speichereinheit RAM abgespeichert.

Bisher wurde angenommen, daß der Zustand des Eingangssignals IN0, nachdem seine Änderung durch das Exklusiv-ODER Gatter EOG detektiert und während dem Zeitintervallsignal SIN0(1) in der bistabilen Kippstufe MSFF abgespeichert war, unverändert verbleibt, so daß man das T-Kippglied TFF0 in einen neuen Zustand geht, Q zu 1 wird (SINO0(5)) und der Inhalt der Reihe 0 der ersten Speichereinheit ROM in der Reihe 0 der zweiten Speichereinheit RAM (SIN1(5)) kopiert wird. Jetzt wird angenommen, daß, nachdem das Ausgangssignal des Exklusiv-ODER Gatters EOG während dem Zeitintervallsignal SIN0(4) in der bistabilen Kippstufe MSFF abgespeichert wurde, vgl. Figur 11, der Zustand des Eingangssignals IN0 sich ändert. Für diesen Fall läuft der folgende Vorgang ab:

**SIN1(4)**   Der Vorgang ist ähnlich dem in Figur 10 beschriebenen Vorgang, d.h.
- das T-Kippglied ist in einem neuen Zustand;
- der Wert 128 wird in der Reihe 0 der zweiten Speichereinheit RAM eingeschrieben, so daß ein Übertragbit in der Speicherzelle RAMC07 vorliegt.

**SIN0(5)**   Aufgrund der Änderung des Eingangssignals IN0 wird der Ausgang des Exklusiv-ODER Gatters EOG zu 1 und der Wert des T-Kippgliedes TFF0 und diese 1 wird in der bistabilen Kippstufe MSFF am Ende dieses Zeitintervalls abgespeichert, so daß $\bar{Q} = 0$ ist.

**SIN1(5)**   Während diesem Zeitintervall wird eine 1 zu dem Inhalt   1 1 1 1 1 0 0 der Reihe 0 der ersten Speichereinheit ROM addiert und das Ergebnis   1 1 1 1 1 0 1 oder 125 wird in der Reihe 0 der zweiten Speichereinheit RAM abgespeichert. Mit dem Abspeichern des Wertes 125 befindet man sich wieder unter den gleichen Bedingungen wie in Figur 10. Wenn die Tatsache, daß die Entprellzeit abgelaufen ist, nicht durch das Übertragbit 1 festgehalten wird, läuft der obige Vorgang für Q = 1 weiter, so daß während den folgenden Zeitintervallen Einsen zu dem Wert 128 addiert werden, bis der gleiche Endwert erreicht würde. Somit würde anstelle einer Entprellzeit von 8ms eine auf 128 x 2 x 2 = 512 ms erweiterete Entprellzeit gezählt.

17

Verzeichnis der verwendeten Bezeichnungen

| | |
|---|---|
| IN0 bis IN7 | Fernsprech- oder Eingangssignal und da gleich benannte Signaleingänge |
| OUT0 bis OUT7 | Signalausgänge |
| ROM | erste Speichereinheit |
| RAM | zweite Speichereinheit |
| HA | Addiereinheit |
| $\overline{S}$ | Summenausgang |
| EOG | Exklusiv-ODER Gatter |
| MEM | dritte Speichereinheit |
| RAMC07/77 | vierte Speichereinheit |
| P | Steuerbit |
| A1 | erster Addiereingang |
| A2 | zweiter Addiereingang |
| $\overline{C}$ | Übertragausgang |
| S70/S76 | erste Schaltglieder |
| S30/S36 | zweite Schaltglieder |
| $Q \cdot \overline{P}$ | erstes Steuersignal |
| Q | verzögertes Ausgangssignal des EOG |
| OR1, NAND1 | drittes Schaltglied |
| $C + Q \cdot SB0$ | zweites Steuersignal |
| SB0 | erstes Zeitablaufsignal |
| SB6 | zweites Zeitablaufsignal |
| TFF0/7 | T-Kippglieder |
| NOR2 | viertes Schaltglied |
| $C \cdot W \cdot SB6$ | drittes Steuersignal |
| MSFF | bistabile Kippstufe |
| W, $\overline{W}$ | Schreibsignal |
| R, $\overline{R}$ | Lesesignal |
| MUX1 | erster Multiplexer |
| MUX2 | zweiter Multiplexer |

| | |
|---|---|
| PS, CR, DEC1/2 | Zeitgeberschaltung aus |
| PS | Taktgenerator |
| CR | Binärzähler |
| a,b,c,d,e,f | Binärausgänge des |
| $\overline{a},\overline{b},\overline{c},\overline{d},\overline{e},\overline{f}$ | Binärzählers CR |
| CL | Taktsignal |
| DEC1 | erste Binär-Dezimalwandlereinheit |
| DEC2 | zweite Binär-Dezimalwandlereinheit |
| SIN0/7, $\overline{SIN0/7}$ | Zeitintervallsignale |
| SB0/7, $\overline{SB0/7}$ | Bittaktsignale |
| HTC | Steuereinheit |
| S86 | erster Schalter |
| S87 | zweiter Schalter |
| S89 | dritter Schalter |
| S88 | vierter Schalter |
| S92 | fünfter Schalter |
| S93 | sechster Schalter |
| S90 | siebter Schalter |
| S91 | achter Schalter |
| S97 | neunter Schalter |
| S94 | zehnter Schalter |
| S95 | elfter Schalter |
| S96 | zwölfter Schalter |
| I6 | erster Inverter |
| I7 | zweiter Inverter |
| I8 | dritter Inverter |
| I9 | vierter Inverter |
| I10 | fünfter Inverter |
| I11 | sechster Inverter |
| I12 | siebter Inverter |
| I13 | achter Inverter |
| I14 | neunter Inverter |

| | |
|---|---|
| NAND2 | |
| NAND3 | NAND-Gatter |
| NAND4 | |
| NOR3 | |
| NOR4 | NOR-Gatter |
| NOR5 | |
| OR2 | ODER-Gatter |
| AND | UND-Gatter |
| I1,I2,I3,I4,I5, | Inverter |
| I15,I16 | |
| S40 bis S47 | |
| S50 bis S57 | |
| S60 bis S67 | Schalter |
| S80 bis S85 | |
| S1 | |
| NT | N-Kanal MOSFET |
| | mit |
| d,4 | Drain-Anschlüsse |
| s,3 | Source-Anschlüsse |
| gn,2 | Gate-Anschlüsse |
| PT | P-Kanal MOSFET |
| | mit |
| d,4 | Drain-Anschlüsse |
| s,3 | Source-Anschlüsse |
| gp,1 | Gate-Anschlüsse |
| TFFØ/7 | T-Kippglieder mit Anschlüssen |
| 1', 2' | Wahleingänge |
| 3', 4' | Dateneingänge |
| 5', 6' | Leseeingänge |
| 7' | Ausgang |
| MSFF | bistabile Kippstufe mit Anschlüssen |
| 1' | Eingang |
| 2', $\overline{Q}$ | Ausgänge |

| | |
|---|---|
| 3', 4'  5', 6' | Steuereingänge |
| RAMC00 | Speicherzelle mit Anschlüssen |
| 1', 2' | Wahleingänge |
| 3' | Dateneingang |
| 4' | Datenausgang |
| 5', 6', 7', 8' | Steuereingänge |
| A, $\overline{A}$ | viertes Steuersignal |
| B, $\overline{B}$ | fünftes Steuersignal |
| B0 bis B6 | Bits, mit B0 = niedrigstwertiges Bit  B6 = höchstwertiges Bit |
| X | binärer Wert zwischen 0 und 127 |
| HT0, HT1 | Steuerbits |
| ROMC00 bis ROMC76 | Speicherzellen der ersten Speicher- einheit |
| RAMC00 bis RAMC77 | "       " zweiten    " |

## Ansprüche

1. Signalerkennungssystem zum Erzeugen eines Ausgangssignalzustandes in Abhängigkeit eines Zustandes eines Eingangssignales, falls der Eingangssignalzustand wenigstens während eines vorgegebenen Zeitintervalles anliegt, wobei das Signalerkennungssystem Mittel zum periodischen Abtasten des Eingangssignalzustandes, eine erste Speichereinheit (ROM) zum Abspeichern eines dem vorgegebenen Zeitintervall entsprechenden Anfangswertes, eine zweite Speichereinheit (RAM) zum Abspeichern eines Wertes, der der Anzahl von Zeiteinheiten entspricht, die seit der Erkennung eines Unterschiedes zwischen einem Eingangs- und einem Ausgangssignalzustand gezählt wurden, eine dritte Speichereinheit (TFF 0/7) zum Abspeichern des Ausgangssignalzustandes und eine Verarbeitungseinheit aufweist zum übertragen des Anfangswertes von der ersten Speichereinheit zu der zweiten Speichereinheit, falls kein Unterschied erkannt wurde und zum Abändern des in der zweiten Speichereinheit abgespeicherten Wertes jedesmal dann, wenn ein Unterschied erkannt wurde und zwar so lange, bis die Anzahl von Zeiteinheiten gezählt wurden, die dem vorgegebenen Zeitintervall entsprechen und zum anschließenden Ändern des Ausgangssignalzustandes in der dritten Speichereinheit, **dadurch gekennzeichnet,** daß in der ersten Speichereinheit (ROM) nur ein einziger Anfangswert für alle Zustände des Eingangssignales abgespeichert wird und daß die Verarbeitungseinheit die zweite Speichereinheit (RAM) mit Hilfe des Anfangswertes initialisiert, welcher im folgenden immer dann durch eine 1-Bit-Addiereinheit (HA) geändert wird, wenn ein Unterschied erkannt wird und zwar unabhängig von der ersten Speichereinheit (ROM).

2. Signalerkennungssystem nach Anspruch 1, dadurch gekennzeichnet, daß die 1-Bit-Addiereinheit (HA) einen Summenausgang (S) enthält, der mit einem Eingang der zweiten Speichereinheit (RAM) verbunden ist und daß die 1-Bit-Addiereinheit (HA) ein Exklusiv-ODER-Gatter (EOG) enthält, das die Eingangs- und Ausgangszustände miteinander vergleicht und im Falle eines erkannten Unterschiedes einen Ausgang der zweiten Speichereinheit (RAM) mit der Addiereinheit (HA) verbindet, die dann einen 1-Wert zu dem in der zweiten Speichereinheit (RAM) abgespeicherten Wert hinzuaddiert und den so erhaltenen Summenwert in der zweiten Speichereinheit (RAM) abspeichert.

3. Signalerekennungssystem nach Anspruch 2, dadurch gekennzeichnet, daß für den Fall, daß die durch das Exklusiv-ODER Gatter (EOG) verglichenen Eingangs- und Ausgangssignalzustände als unterschiedlich erkannt wurden, nachdem der Ausgangssignalzustand gerade in der dritten Speichereinheit (MEM) gewechselt wurde, durch die Addiereinheit (HA) ein Null-Wert zu dem Anfangswert der ersten Speichereinheit (ROM) addiert und der Summenwert in der zweiten Speichereinheit (RAM) abgespeichert wird.

4. Signalerkennungssystem nach Anspruch 2, dadurch gekennzeichnet, daß für den Fall, daß die durch das Exklusiv-ODER Gatter (EOG) verglichene Eingangs- und Ausgangssignalzustände gleich sind, durch die Addiereinheit (HA) ein Null-Wert zu dem Anfangswert der ersten Speichereinheit (ROM) addiert und der Summenwert in der zweiten Speichereinheit (RAM) abgespeichert wird.

5. Signalerkennungssystem nach Anspruch 1, dadurch gekennzeichnet, daß die Verarbeitungseinheit eine vierte Speichereinheit (RAMC∅7/77) zum Abspeichern eines Steuerbits (P) enthält, das in Abhängigkeit des in der zweiten Speichereinheit (RAM) abgespeicherten Wertes gesetzt oder nicht gesetzt wird, wenn das vorgegebene Zeitintervall erreicht bzw. nicht erreicht wird.

6. Signalerkennungssystem nach Anspruch 3,4 und 5, dadurch gekennzeichnet, daß die Addiereinheit (HA) einen ersten Addiereingang (A1), einen zweiten Addiereingang (A2) und einen übertragausgang ( $\overline{C}$ ) aufweist, daß Ausgänge der ersten und zweiten Speichereinheit (ROM, RAM) an den ersten Addiereingang (A1) über erste Schaltglieder (S7∅/S76) bzw. zweite Schaltglieder (S3∅/S36) angeschlossen sind und mittels eines ersten Steuersignals Q, $\overline{P}$ komplementär gesteuert werden, wobei durch P das Steuerbit (P) und durch Q das verzögerte Ausgangssignal des Exklusiv-ODER Gatters (EOG) dargestellt werden und daß der übertragausgang ( $\overline{C}$ ) und der Ausgang des Exklusiv-ODER Gatters (EOG) über ein drittes Schaltglied (OR1, NAND1) an den zweiten Addiereingang (A2) angeschlossen sind und an seinem Ausgang ein zweites Steuersignal C + Q • SB∅ erzeugt wird, wobei durch C das an dem übertragausgang ( $\overline{C}$ ) anliegende übertragsignal und durch SB∅ ein erstes Zeitablaufsignal dargestellt wird.

7. Signalerkennungssystem nach Anspruch 6, dadurch gekennzeichnet, daß die dritte Speichereinheit (MEM) aus T-Kippgliedern (TFF∅/7) zusammengesetzt und durch ein mittels eines vierten Schaltgliedes (NOR2) gebildeten dritten Steuersignals C•W•SB6 gesteuert wird, wobei durch W ein Schreibsignal und durch SB6 ein zweites Zeitablaufsignal dargestellt wird.

8. Signalerkennungssystem nach Anspruch 6, dadurch gekennzeichnet, daß der Ausgang des Exklusiv-ODER Gatters (EOG) an einen Eingang einer bistabilen Kippstufe (MSFF) angeschlossen ist, wobei durch die bistabile Kippstufe (MSFF) das verzögerte Ausgangssignal Q erzeugt wird.

9. Signalerkennungssystem nach Anspurch 1, dadurch gekennzeichnet, daß ein erster Multiplexer (MUX1) an Signaleingänge (IN∅/7) des Signalerkennungssystems, an denen die Eingangssignalzustände angelegt werden, angeschlossen ist, daß Eingänge eines zweiten Multiplexers (MUX2) an entsprechende Ausgänge einer Vielzahl von dritten Speichereinheiten (TFF∅/7) angeschlossen sind und daß Ausgänge des ersten Multiplexers (MUX1) und des zweiten Multiplexers (MUX2) entsprechend mit Eingängen eines Exklusiv-ODER Gatters (EOG) verbunden sind.

10. Signalerkennungssystem nach Anspruch 5 und 9, dadurch gekennzeichnet, daß durch das Signalerkennungssystem Erzeugen einer Vielzahl von Ausgangssignalzuständen in Abhängigkeit von Eingangssignalzuständen jeder in der ersten Speichereinheit (ROM) und der zweiten Speichereinheit (RAM) abzuspeichernde Wert in Form einer Vielzahl von Bits abgespeichert wird, daß das Signalerkennungssystem eine Zeitgeberschaltung (PS, CR, DEC1/2) aufweist, durch die eine Vielzahl von aufeinanderfolgenden Zeitintervalsignale (SIN∅/7) erzeugt und zu entsprechenden Zeitintervallen der Eingangssignalzustände zugeordnet werden und durch die der erste Multiplexer (MUX1) und der zweite Multiplexer (MUX2) gesteuert werden und daß durch die Zeitgeberschaltung (PS, CR, DEC1/2) für jedes Zeitintervallsignal (SIN∅/7) eine Reihe aufeinanderfolgender Bittaktsignale (SB∅/7) erzeugt werden, die zu entsprechenden Bits der abgespeicherten Werte und dem Steuerbit (P) zugeordnet werden.

11. Signalerkennungsssstem nach Anspruch 7 und 10, dadurch gekennzeichnet, daß die Addiereinheit (HA) einen 1-Bit Addierer aufweist, durch den ein Null-Wert oder ein Eins-Wert zu den in der ersten Speichereinheit (ROM) und der zweiten Speichereinheit (RAM) abgespeicherten Werten addiert wird, daß das erste Zeitablaufsignal (SBØ) und das zweite Zeitablaufsignal (SB6) dem ersten Bittaktsignal (SBØ) bw. dem vorletzten Bittaktsignal (SB6) in jeder der Reihe aufeinanderfolgender Bittaktsignale (SBØ/) entsprechen und dem ersten Bit bzw. dem letzten Bit jedes der in der ersten Speichereinheit (ROM) und der zweiten Speichereinheit (RAM) abgespeicherten Werte zugeordnet werden und daß das letzte Bittaktsignal (SB7) in jeder Reihe der aufeinanderfolgenden Bittaktsignale (SBØ/7) dem Steuerbit (P) zugeordnet wird.

12. Signalerkennungssystem nach Anspruch 11, dadurch gekennzeichnet, daß für die Zeitdauer des letzten Bittaktsignales (SB7) ein Null-Wert an den ersten Addiereingang (A1) der Addiereinheit (HA) angelegt wird.

13. Signalerkennungssystem nach Anspruch 1,dadurch gekennzeichnet, daß es eine Steuereinheit (HTC) aufweist, die mit der ersten Speichereinheit (ROM) zum Abändern der dort gespeicherten Anfangswerte verbunden ist.

14. Signalerkennungssystem nach Anspruch 7 und 9, dadurch gekennzeichnet, daß das T-Kippglied (TFFØ/7) eine erste Kaskadenschaltung aus einem ersten Schalter (S86) einem zweiten Schalter (S87), einem ersten Inverter (I6), einem zweiten Inverter (I7), einem dritten Schalter (S89) und einem dritten Inverter (I8), sowie eine zweite Kaskadenschaltung aus dem ersten Inverter (I6), dem zweiten Inverter (I7) und einem vierten Schalter (S88) aufweist, daß der Verbindungspunkt des ersten Inverters (I6) und des zweiten Inverters (I7) den Ausgang des T-Kippgliedes (TFFØ/7) bildet, daß der erste Schalter (S86) durch ein entsprechend zugeordnetes Zeitintervallsignal (SINØ/7) gesteuert wird, daß der zweite Schalter (S87) durch ein Ausgangssignal des vierten Schaltgliedes (NOR2) gesteuert wird und daß der dritte Schalter (S89) und der vierte Schalter (S88) durch ein Lesesignal (R) gesteuert werden.

15. Signalerkennungssystem nach Anspruch 8 und 11, dadurch gekennzeichnet, daß die bistabile Kippstufe (MSFF) aus einem Master-Slave-Kippglied besteht, das eine Kaskadenschaltung aus einem vierten Inverter (I9), einem fünften Inverter (I1Ø), und einem fünften Schalter (S92),sowie eine Kaskadenschaltung aus einem sechsten Inverter (I11) einem siebten Inverter (I12) und einem sechsten Schalter (S93) enthält, daß ein Dateneingang (1') der bistabilen Kippstufe (MSFF) mit deren Datenausgang (2') über eine Kaskadenschaltung aus einem siebten Schalter (S90), dem vierten Inverter (I9), dem fünften Inverter (I1Ø), einem achten Schalter (S91) und dem sechsten Inverter (I11) verbunden ist, daß der sechste Schalter (S93) und der siebte Schalter (S9Ø) durch ein viertes Steuersignal (A) gesteuert werden, welches für die Zeitdauer der letzten Bittaktsignales (SB7) und des ersten Bittaktsignales (SBØ) abgeschaltet ist und daß der fünfte Schalter (S92) und der achte Schalter (S91) durch ein fünftes Steuersignal (B) gesteuert werden, welches beginnend mit dem Ende des letzten Bittaktsignales (SB7) für die Zeitdauer eines Bittaktes eingeschaltet ist.

16. Signalerkennungssystem nach Anspruch 10, dadurch gekennzeichnet, daß jede Speicherzelle der zweiten Speichereinheit (RAM) eine Schleife aus einer Kaskadenschaltung von einem achten Inverter (I13), einem neunten Inverter (I14) und einem neunten Schalter (S97) aufweist, daß ein Dateneingang (3') der Speicherzelle über eine Kaskadenschaltung aus einem zehnten Schalter (S94), einem elften Schalter (S95), dem achten Inverter (I13) dem neunten Inverter (I14) und einem zwölften Schalter (S96) mit einem Datenausgang (4') der Speicherzelle verbunden ist, daß der elfte Schalter (S95) und der zwölfte Schalter (S96) durch ein entsprechendes Zeitintervallsignal (SINØ/7) gesteuert wird, daß der neunte Schalter (S97) durch ein Lesesignal (R) jedes Bittaktsignales (SBØ/7) gesteuert wird und daß der zwölfte Schalter (S94) durch ein gegen Ende jedes Bittaktsignales (SBØ/7) auftretendes Schreibsignal (W) gesteuert wird.

17. Signalerkennungssystem nach Anspruch 1, dadurch gekennzeichnet, daß die Eingangssignalzustände den auf einer Fernmeldeleitung auftretenden Zuständen entsprechen.

## Claims

1. Signal recognition system for producing a condition of an outut signal as a condition of an input signal only when said input signal condition persists for at least a predetermined time interval, said system including a unit for periodically scanning said input signal condition; a first memory unit (ROM) for

EP 0 146 938 B1

storing a start value corresponding to the predetermined time inverval; a second memory unit (RAM) for storing a value corresponding to the number of the time units already counted since the detection of a difference between said input and output signal conditions; a third memory unit (TFF0/7) for storing the output signal condition; and a processing unit for bringing said start value from said first memory unit into said second memory unit when no difference is detected and for modifying the value in said second memory unit each time such a difference is detected and namely until the number of time units corresponding to the predetermined time interval has been counted, and for then modifying said output signal condition in said third memory unit , characterized in that said first memory unit (ROM) only stores a single start value for all conditions of said input signal and that said processing unit initialises said second memory unit (RAM) with said start value which is afterwards modified by a one-bit adder circuit (HA) each time said difference is detected and independently from the first memory unit (ROM).

2. Signal recognition system according to claim 1, characterized in that said one-bit adder circuit (HA) has a sum output (S) coupled to an input of said second memory unit (RAM) and that it further includes an exclusive -OR gate (EOG) which compares said input and output signal conditions and which when the result of this comparison indicates a difference couples an output of said second memory unit (RAM) to said adder circuit (HA) which then adds a 1 to the value stored in said second memory unit (RAM) and stores the sum value thus obtained into said second memory unit (RAM).

3. Signal recognition system according to claim 2, characterized in that when said input and output signal conditions compared by said gate (EOG) are found to be different after said output signal condition has just been changed in said third memory unit (MEM), said adder circuit (HA) adds a 0 to the start value stored in said first memory unit (ROM) and stores the sum value thus obtained into said second memory unit (RAM).

4. Signal recognition system according to claim 2, characterized in that when said input and output signal conditions compared by said gate (EOG) are equal, said adder circuit (HA) adds a 0 to the value stored in said first memory unit (ROM) and stores the sum value thus obtained into said second memory unit (RAM).

5. Signal recognition system according to claim 1, characterized in that said processing unit includes a fourth memory unit (RAMC07/77) for storing a control bit (P) indicative of the fact that the value stored in said second memory unit (RAM) indicates that said time interval has been counted or not.

6. Signal recognition system according to claims 3, 4 and 5, characterized in that said adder circuit (HA) further has a first adder input (A1), a second adder input (A2) and a carry output (C), that outputs of said first (ROM) and second (RAM) memory units are coupled to said first adder input (A1) via respective first (S70/76) and second (S30/36) switching member controlled in a complementary way be a first control signal Q.P wherein P is said control bit and Q is the delayed output signal of said gate (EOG) and that said carry output (C) and the output of said gate (EOG) are coupled to said second adder input (A2) via a third switching member (OA1, NAND1) providing at its output a second control signal C + Q.SB0, wherein C is a carry signal provided at said carry output and SB0 is a first timing signal.

7. Signal recognition system according to claim 6, characterized in that said third memory unit is constituted by a toggle flipflop (TFF0/7) which is controlled by a third control signal C.W.SB6 provided by a fourth switching member (NOR2), wherein W is a write signal and SB6 is a second timing signal.

8. Signal recognition system according to claim 6, characterized in that the output of said gate (EOG) is coupled to an input of a bistate device (MSFF) providing said signal Q.

9. Signal recognition system according to claim 1, characterized in that it includes a first multiplexer (MUX1) to the inputs (IN0/7) of which said input signal conditions are applied, and a second multiplexer (MUX2) whose inputs are coupled to outputs of a plurality of corresponding third memory units (TFF0/7), the outputs of said first and second multiplexers being coupled to respective inputs of said exclusive -OR gate (EOG).

10. Signal recognition system according to claims 5 and 9, characterized in that it is adapted to produce a

24

plurality of input signal conditions as output signal conditions and to store each of the values in said first (ROM) and second (RAM) memory units under the form of a plurality of bits, and that it includes a timing cirucit (PS, CR, DEC1/2) which generates a plurality of successive time interval signals (SIN0/7), allocated to respective ones of said input signal conditions, and controlling said multiplexer, and moreover generates in each such ti me interval signal (SIN0/7) a series of successive bit period signals (SB0/7) allocated to respective ones of said bits of said values and to said control bit (P).

**11.** Signal recognition system according to claims 7 and 10, characterized in that said adder circuit (HA) is a 1-bit adder able to add a 0 or a 1 to the values stored in said first (ROM) and said second (RAM) memory units, and that said first (SB0) and second (SB6) timing signals are the first and penultimate bit period signals of said series and are allocated to the first and last bits of the values stored in each of said first (ROM) and second (RAM) memory units respeotively, and that the last bit period signal (SB7) of said series (SB0/7) is allocated to said control bit (P).

**12.** Signal recognition system according to claim 11, characterized in that during said last bit period signal (SB7) a 0 is applied to said first adder input (A1).

**13.** Signal recognition system according to claim 1, characterized in that it includes a control unit (HTC) coupled to said first memory unit (ROM) to modify the start value stored therein.

**14.** Signal recognition system according to claims 7 and 9, characterized in that said toggle flipflop (TFF0/7) includes a first and a second loop, said first loop comprising the cascade connection of a first switch (S86), a second switch (S87), a first inverter (I0), a second inverter (I7), a third switch (S89) and a third inverter (I8), whilst said second loop comprises the cascade conneotion of said first (I6) and second (I7) inverters and of a fourth switch (S88), the junction point of said first (I6) and second (I7) inverters constituting the output of said toggle flipflop, said first switch (S86) being controlled by a respective one of said time interval signals (SIN0/7), said second switch (S87) being controlled by an output signal of said fourth switching member (NOR2) and said third (S89) and fourth (S88) switches being controlled by a read signal (S).

**15.** Signal recognition system according to claims 8 and 11, characterized in that said bistate device (MSFF) is a master/slave flipflop including a slave loop and a master loop, said slave loop comprising the cascade connection of a fourth (I9) and a fifth (I10) inverter and a fifth switch (S92) and said master loop comprising the cascade connection of a sixth (I11) and a seventh (I12) inverter and a sixth switch (S93), and that a data input (1') of said flipflop is connected to the output (2') thereof via the cascade connection of a seventh switch (S90), said fourth (I9) and fifth (I10) inverters, an eighth switch (S91) and said sixth (I11) and seventh (I12) inverters, said sixth (S93) and seventh (S90) switches being controlled by a fourth control signal (A) which is deactivated for substantially said last (SB7) and first (SB0) bit period signals and said fifth (S92) and eighth (S91) switches being controlled by a fifth control signal (B) which is activated from the end of said last bit period signal (SB7) for substantially one such time period.

**16.** Signal recognition system aocording to claim 10, characterized in that eaoh memory cell of said second memory means (RAM) includes a loop comprising the cascade connection of eighth (I13) and ninth (I14) inverters and a ninth switch (S97), said cell having a data input (3') and a data output (4') which are connected via the cascade connection of tenth (S94) and eleventh (S95) switches, said eighth (I13) and ninth (I14) inverters and a twelfth switch (S97) and that said eleventh (S95) and twelfth (S96) switches are controlled by a corresponding time interval signal (SIN0/7), said ninth switch (S97) is controlled by a read signal (R) of each bit period signal (SB0/7) and said twelfth switch (S94) is controlled by a write signal near the end of each such bit period signal.

**17.** Signal recognition system according to claim 1, characterized in that said input signal conditions are those of a telecommunication line.

**Revendications**

**1.** Système de reconnaissance de signaux pour produire un état d'un signal de sortie en fonction d'un état

25

d'un signal d'entrée, dans le cas où l'état du signal d'entrée est maintenu au moins pendant un intervalle de temps prédéterminé, le système de reconnaissance de signaux comprenant une unité pour analyser périodiquement l'état du signal d'entrée, une première unité de mémoire (ROM) pour la mémorisation d'une valeur initiale correspondant à l'intervalle de temps prédéterminé, une seconde unité de mémoire (RAM) pour la mémorisation d'une valeur qui correspond au nombre d'unités de temps qui ont été comptées depuis la détection d'une différence entre un état du signal d'entrée et un état du signal de sortie, une troisième unité de mémoire (TFF 0/7) pour la mémorisation de l'état du signal de sortie et une unité de traitement pour le transfert de la valeur initiale de la première unité de mémoire à la seconde unité de mémoire, dans le cas où aucune différence n'a été détectée, et pour modifier la valeur mémorisée dans la seconde unité de mémoire à chaque fois qu'une différence a été détectée, et notamment jusqu'à ce que le nombre d'unités de temps, qui correspondent à l'intervalle de temps prédéterminé, ait été compté, et pour modifier ensuite l'état du signal de sortie dans la troisième unité de mémoire, caractérisé en ce que, dans la première unité de mémoire (ROM), seulement une unique valeur initiale est mémorisée pour tous les états du signal d'entrée et en ce que l'unité de traitement assure l'initialisation de la seconde unité de mémoire (RAM) à l'aide de la valeur initiale, qui est modifiée par la suite toujours par une unité d'addition de bit-1 (HA), lorsqu'une différence est détectée, et notamment indépendamment de la première unité de mémoire (ROM).

2. Système de reconnaissance de signaux selon la revendication 1, caractérisé en ce que l'unité d'addition de bit-1 (HA) contient une sortie de sommes (S), qui est reliée à une entrée de la seconde unité de mémoire (RAM), et en ce que l'unité d'addition de bit-1 (HA) contient une porte OU-exclusif (EOG), qui compare les états d'entrée et de sortie entre eux et qui, lors de la détection d'une différence, relie une sortie de la seconde unité de mémoire (RAM) avec l'unité d'addition (HA), qui effectue alors l'addition d'une valeur-1 à la valeur mémorisée dans la seconde unité de mémoire (RAM) et qui mémorise la valeur de somme ainsi obtenue dans la seconde unité de mémoire (RAM).

3. Système de reconnaissance de signaux selon la revendication 2, caractérisé en ce que, dans le cas où les états des signaux d'entrée et de sortie comparés par la porte OU-exclusif (EOG) ont été détectés comme différents, après que l'état du signal de sortie a été précisément modifié dans la troisième unité de mémoire (MEM), une valeur-zéro est additionnée par l'unité d'addition (HA) à la valeur initiale de la première unité de mémoire (ROM) et la valeur de somme est mémorisée dans la seconde unité de mémoire (RAM).

4. Système de reconnaissance de signaux selon la revendication 2, caractérisé en ce que, dans le cas où les états des signaux d'entrée et de sortie qui ont été comparés par la porte OU-exclusif (EOG) sont identiques, une valeur-zéro est additionnée par l'unité d'addition (HA) à la valeur initiale de la première unité de mémoire (ROM) et la valeur de somme est mémorisée dans la seconde unité de mémoire (RAM).

5. Système de reconnaissance de signaux selon la revendication 1, caractérisé en ce que l'unité de traitement contient une quatrième unité de mémoire (RAMCφ7/77) pour la mémorisation d'un bit de commande (P) qui est activé ou n'est pas activé, en fonction de la valeur mémorisée dans la seconde unité de mémoire (RAM), lorsque l'intervalle de temps prédéterminé est atteint, ou n'est pas atteint.

6. Système de reconnaissance de signaux selon une des revendications 3, 4 et 5, caractérisé en ce que l'unité d'addition (HA) comporte une première entrée d'addition (A1), une seconde entrée d'addition (A2) et une sortie de report ($\overline{C}$), en ce que des sorties de la première et de la seconde unité de mémoire (ROM, RAM) sont reliées à la première entrée d'addition (A1) par l'intermédiaire d'un premier organe de commutation (S7φ/S76) ou bien d'un second organe de commutation (S3φ/S36) et sont commandées de façon complémentaire au moyen d'un premier signal de commande Q . $\overline{P}$, le bit de commande (P) étant représenté par P tandis que le signal de sortie retardé de la porte OU-exclusif (EOG) est représenté par Q, et en ce que la sortie de report ($\overline{C}$) et la sortie de la porte OU-exclusif (EOG) sont reliées, par l'intermédiaire d'un troisième organe de commutation (OR1, NAND1) à la seconde entrée d'addition (A2) qui produit à sa sortie un second signal de commande C + Q . SBφ, auquel cas le signal de report apparaissant à la sortie de report ($\overline{C}$) est représenté par C tandis qu'un premier signal de déroulement temporel est représenté par SBφ.

7. Système de reconnaissance de signaux selon la revendication 6, caractérisé en ce que la troisième unité de mémoire (MEM) est composée de bascules-T (TFF∅/7) et elle est commandée par un troisième signal de commande C . W . SB6, formé à l'aide d'un quatrième organe de commutation (NOR2), un signal d'écriture étant représenté par W tandis qu'un second signal de déroulement temporel est représenté par SB6.

8. Système de reconnaissance de signaux selon la revendication 6, caractérisé en ce que la sortie de la porte OU-exolusif (EOG) est reliée à une entrée d'une bascule bistable (MSFF), le signal de sortie retardé Q étant reproduit par la bascule bistable (MSFF).

9. Système de reconnaissance de signaux selon la revendication 1, caractérisé en ce qu'un premier multiplexeur (MUX1) est relié à des entrées de signaux (IN∅/7) du système de reconnaissance de signaux, auxquelles les états des signaux d'entrée sont appliqués, en ce que les entrées d'un second multiplexeur (MUX2) sont reliées à des sorties correspondantes d'un grand nombre de troisièmes unités de mémorisation (TFF∅/7) et en ce que des sorties du premier multiplexeur (MUX1) et du second multiplexeur (MUX2) sont reliées en correspondance à des entrées d'une porte OU-exclusif (EOG).

10. Système de reconnaissance de signaux selon une des revendications 5 et 9, caractérisé en ce qu'un grand nombre d'états de signaux de sortie sont produits par le système de reconnaissance de signaux en fonction d'états de signaux d'entrée, de telle sorte que chaque valeur à mémoriser dans la première unité de mémorisation (ROM) et dans la seconde unité de mémorisation (RAM) soit effectivement mémorisée sous la forme d'un grand nombre de bits, en ce que le système de reconnaissance de signaux comporte un circuit de régulation temporelle (PS, CR, DEC1/2) par lequel sont produit un grand nombre de signaux d'intervalles de temps successifs (SIN∅/7) qui sont associés à des intervalles de temps correspondants des états des signaux d'entrée et par lesquels le premier multiplexeur (MUX1) et le second multiplexeur (MUX2) sont commandés , et en ce que le circuit de régulation temporelle (PS, CR, DEC1/2) produit pour chaque signal d'intervalle de temps (SIN∅/7) une série de signaux de périodes de bits successifs (SB∅/7) , qui sont associés à des bits correspondants des valeurs mémorisées et au bit de commande (P).

11. Système de reconnaissance de signaux selon les revendications 7 et 10, caractérisé en ce que l'unité d'addition (HA) comporte un additionneur de bit-1, par lequel une valeur-zéro ou une valeur-un est additionnée aux valeurs mémorisées dans la première unité de mémoire (ROM) et la seconde unité de mémoire (RAM), en ce que le premier signal de déroulement temporel (SB∅) et le second signal de déroulement temporel (SB6) correspondent au premier signal de période de bit (SB∅) ou à l'avant-dernier signal de période de bit (SB6) dans chacune des rangées de signaux de périodes de bits successifs (SB∅/7) et sont associés au premier bit ou au dernier bit de chacune des valeurs mémorisées dans la première unité de mémoire (ROM) et la seconde unité de mémoire (RAM) et en ce que le dernier signal de période de bit (SB7) est associé, dans chaque rangée de signaux de périodes de bits successifs (SB∅/7) au bit de commande (P).

12. Système de reconnaissance de signaux selon la revendication 11, caractérisé en ce que, pendant la durée du dernier signal de période de bit (SB7), une valeur-zéro est appliquée à la première entrée d'addition (A1`) de l'unité d'addition (HA).

13. Système de reconnaissance de signaux selon la revendication 1, caractérisé en ce qu'il comporte une unité de commande (HTC), qui est reliée à la première unité de mémoire (ROM) pour modifier les valeurs initiales mémorisées dans celle-ci.

14. Système de reconnaissance de signaux selon les revendications 7 et 9, caractérisé en ce que la bascule-T (TFF∅/7) comporte un circuit en cascade se composant d'un premier commutateur (S86), d'un second commutateur (S87), d'un premier inverseur (I6), d'un second inverseur (I7), d'un troisième commutateur (S89) et d'un troisième inverseur (I8), ainsi qu'un second circuit en cascade se composant du premier inverseur (I6), du second inverseur (I7) et d'un quatrième commutateur (S88), en ce que le point de jonction du premier inverseur (I6) et du second inverseur (I7) constitue la sortie de la bascule-T (TFF∅/7), en ce que le premier commutateur (S86) est commandé par un signal d'intervalle de temps (SIN∅/7) associé en correspondance, en ce que le second commutateur (S87) est commandé par un signal de sortie du quatrième organe de commutation (NOR2) et en ce que le troisième commutateur (S89) et le quatrième commutateur (S88) sont commandés par un signal de lecture (R).

15. Système de reconnaissance de signaux selon les revendications 8 et 11, caractérisé en ce que la bascule bistable (MSFF) se compose d'un organe basculant maître-esclave, qui contient un circuit en cascade se composant d'un quatrième inverseur (I9), d'un cinquième inverseur (I10), et d'un cinquième commutateur (S92), et également d'un circuit en cascade se composant d'un sixième inverseur (I11), d'un septième inverseur (I12) et d'un sixième commutateur (S93), en ce qu'une entrée de données (1') de la bascule bistable (MSFF) est reliée à la sortie de données (2') par l'intermédiaire d'un circuit en cascade se composant d'un septième commutateur (S90), du quatrième inverseur (I9), du cinquième inverseur (I10), d'un huitième commutateur (S91) et du sixième inverseur (I11), en ce que le sixième commutateur (S93) et le septième commutateur (S9$\emptyset$) sont commandés par un quatrième signal de commande (A), qui est supprimé pendant la durée du dernier signal de période de bit (SB7) et du premier signal de période de bit (SB$\emptyset$) et en ce que le cinquième commutateur (S92) et le huitième commutateur (S91) sont commandés par un cinquième signal de commande (B), qui est enclenché au moment de la fin du dernier signal de période de bit (SB7) pendant la durée d'une période de bit.

16. Système de reconnaissance de signaux selon la revendication 10, caractérisé en ce que chaque cellule de mémorisation de la seconde unité de mémoire (RAM) comporte une boucle se composant d'un circuit en cascade comprenant un huitième inverseur (I13), un neuvième inverseur (I14) et un neuvième commutateur (S97), en ce qu'une entrée de données (3') de la cellule de mémorisation est reliée par l'intermédiaire d'un circuit en cascade se composant d'un dixième commutateur (S94), d'un onzième commutateur (S95), du huitième inverseur (I13), du neuvième inverseur (I14) et d'un douzième commutateur (S96), avec une sortie de données (4') de la cellule de mémorisation, en ce que le onzième commutateur (S95) et le douzième commutateur (S96) sont commandés par un signal d'intervalle de temps correspondant (SIN$\emptyset$/7), en ce que le neuvième commutateur (S97) est commandé par un signal de lecture (R) de chaque signal de période de bit (SB$\emptyset$/7) et en ce que le douzième commutateur (S94) est commandé par un signal d'écriture (W) se produisant à la fin de chaque signal de période de bit (SB$\emptyset$/7).

17. Système de reconnaissance de signaux selon la revendication 1, caractérisé en ce que les états des signaux d'entrée correspondent aux états se produisant dans une ligne de télécommunication.

FIG. 1

EP 0 146 938 B1

FIG.2

EP 0 146 938 B1

FIG.4

MSFF

FIG.6

RAMCØØ

FIG.3

TFF Ø

FIG.5

HA

FIG.8

FIG.7

FIG.9

EP 0 146 938 B1

SIN     SIN 0(0)    SIN 1(0)    SIN 0(1)    SIN 1(1)    SIN 1(2)

SB   6   7   0   1    6   7   0   1    6   7   0   1    6   7   0   1    6   7

EOG   0    I    1    I    I

Q̄   I    1    I    0    0

RAM     124     125     126

**FIG. 10**

SIN     SIN 1(3)    SIN 0(4)    SIN 1(4)    SIN 0(5)

SB   0   1    6   7   0   1    6   7   0   1    6   7   0   1    6   7

EOG    I    1    I    0

Q̄    0    I    0    I   1

RAM     127     128

SIN     SIN 0(4)    SIN 1(4)    SIN 0(5)    SIN 1(5)

SB   0   1    6   7   0   1    6   7   0   1    6   7   0   1    6   7

EOG    1    I    1    I

Q̄    I    0    I    0

RAM       128      125

**FIG. 11**